# EUROPEAN PATENT APPLICATION

(11) **EP 4 528 922 A1**
(43) Date of publication of application: **26.03.2025**
(21) Application number: 22944975.6
(22) Date of filing: 31.05.2022
(51) Int. Cl.: H01Q 1/32, H01Q 5/20, H01Q 1/38, H04B 7/0413

(54) **WIDEBAND ANTENNA ARRANGED ON VEHICLE**

(71) Applicant: LG Electronics Inc., Yeongdeungpo-gu Seoul 07336 (KR)
(72) Inventor: KIM, Changil, Seoul 06772 (KR); YUN, Changwon, Seoul 06772 (KR); YOUN, Yeomin, Seoul 06772 (KR)
(74) Representative: Vossius & Partner Patentanwälte Rechtsanwälte mbB
(86) International application number: PCT/KR2022/007758
(87) International publication number: WO 2023/234436

(57) **Abstract**

An antenna assembly mounted on a vehicle may comprise: an inner cover formed of a dielectric material and having a front surface, and one side and the other side which extend from the front surface; a conductive pattern extending from a feed point in the front surface of the inner cover to the one side of the inner cover; a metal frame in contact with one point in the conductive pattern and allowing the conductive pattern to be connected to the ground at the one point; and a slot region formed between the conductive pattern and the metal frame. The conductive pattern may be configured to have a tapering shape from the one side to the feed point in the front surface to transmit and receive wireless signals.

## Description

### Technical Field

The present disclosure relates a wideband antenna arranged on a vehicle. A particular implementation relates to an antenna assembly having a wideband antenna capable of operating in various communication systems, and to a vehicle having the antenna assembly.

### Background Art

A vehicle may perform wireless communication services with other vehicles or nearby objects, infrastructures, or a base station. In this regard, various communication services may be provided using long term evolution (LTE) communication, fifth generation (5G) communication, or WiFi communication technology.

In order to provide these various wireless communication services in a vehicle, an antenna may be disposed on glass of the vehicle, above or below a roof of the vehicle. When the antenna is disposed on the glass of the vehicle, it may be implemented with a transparent antenna material. Meanwhile, when the antenna is disposed above or below the roof of the vehicle, an effect on a vehicle body and the roof of the vehicle may cause a change in antenna performance.

In this regard, since the vehicle body and the vehicle roof are made of a metal material, there is a problem in that radio waves are shielded when wireless communication is performed via the antenna. Accordingly, a method of performing wireless communication by placing an antenna inside a vehicle may be taken into account. In relation to this, considering that a monitor structure tends to be located in a rear seat of a vehicle, an antenna may be placed in a monitor structure placed in a rear seat of a vehicle.

Meanwhile, an antenna element needs to operate in a wide band to provide various communication services other than fourth generation (4G)/5G communication services to vehicles. The antenna element needs to operate as a radiator in a low band (LB), a mid band (MB), a high band (HB), and an ultra-high band (UHB) for 4G/5G wireless communication. In addition, there is such a problem that an interference between antenna elements may occur since the antenna elements are placed in a limited region of an antenna assembly of the monitor structure.

### Disclosure of Invention

### Technical Problem

The present disclosure is directed to solving those problems and other drawbacks. In addition, another aspect of the present disclosure is to provide, within a vehicle, an antenna assembly in which a plurality of antennas for fourth generation (4G)/fifth generation (5G) communications are disposed.

Another object of the present disclosure is to implement an antenna element configured to operate as a radiator in a wide band including a low band (LB), a mid band (MB), a high band (HB) and an ultra-high band (UHB) for 4G/5G communications.

Another object of the present disclosure is to provide a radiator structure for improving antenna characteristics, particularly, in the low band (LB).

Another object of the present disclosure is to provide 4G/5G wireless communication in a vehicle by arranging at least one antenna element inside a monitor structure installed in a rear seat of a vehicle.

Another object of the present disclosure is to provide an antenna arrangement structure for minimizing an interference between antenna elements, as the antenna elements are arranged in a limited region of an antenna assembly in a monitor structure.

Another aspect of the present disclosure is to present a structure for mounting, in a vehicle, an antenna assembly capable of operating in a wide band to support various communication systems.

### Solution to Problem

To achieve these and other advantages and in accordance with the purpose of the present disclosure, as embodied and broadly described herein, there is provided an antenna assembly mounted on a vehicle, the antenna assembly including: an inner cover made of a dielectric material and having a front surface, and one side surface and another side surface each extending from the front surface; a conductive pattern disposed to extend from a feed point on the front surface of the inner cover to the one side surface of the inner cover; a metal frame disposed to be in contact with one point in the conductive pattern to allow the conductive pattern to be connected to ground at the one point; and a slot region disposed between the conductive pattern and the metal frame. The conductive pattern may be configured to have a tapering shape from the one side surface toward the feed point on the front surface to transmit or receive a wireless signal.

According to an embodiment, the antenna assembly may further include an outer cover coupled to the inner cover.

According to an embodiment, the conductive pattern may extend from both end portions of the one side surface to the front surface to define a first end point and a second end point. The first end point of the conductive pattern may be disposed to be curved toward the feed point and the second end point of the conductive pattern may be disposed to be curved toward the feed point so that the conductive pattern transmits or receives a wideband wireless signal.

According to an embodiment, the conductive pattern may include: a first conductive pattern configured to have a tapering shape from the one side surface of the inner cover toward the feed point on the front surface of the inner cover; and a second conductive pattern extending from a first end portion of the one side surface to the front surface to define the first end point. The conductive pattern may further include a third conductive pattern extending from a second end portion of the one side surface to the front surface to define the second end point. The first end point of the second conductive pattern may be disposed to be curved toward the feed point, and the second end point of the third conductive pattern is disposed to be curved toward the feed point.

According to an embodiment, the inner cover may further include an inclined region disposed to be inclined between the front surface and the one side surface. The first conductive pattern may include: a first sub-pattern disposed on the front surface of the inner cover to have a tapering shape and having a feed point at an end portion; a second sub-pattern disposed on the inclined region of the inner cover to have a tapering shape; and a third sub-pattern disposed on the one side surface of the inner cover to have a first width and a first length. A distance between points connecting from the second sub-pattern to the third sub-pattern may be configured as a second width smaller than the first width. A distance between points connecting from the first sub-pattern to the second sub-pattern may be configured to as a third width smaller than the second width.

According to an embodiment, the second conductive pattern may be connected to the third sub-pattern in the inclined region of the inner cover, and the first end point may be disposed to be curved inwardly toward the feed point. The third conductive pattern may be connected to the third sub-pattern in the inclined region of the inner cover, and the second end point may be disposed to be curved inwardly toward the feed point.

According to an embodiment, the second conductive pattern may be disposed in a first end portion of the first conductive pattern to have a fourth width, and spaced apart from the second sub-pattern by a first gap. The third conductive pattern may be disposed in a second end portion of the first conductive pattern to have a fifth width, and spaced apart from the second sub-pattern by a second gap. A sum of the second width, the fourth width, the fifth width, the first gap, and the second gap may be configured to be identical to the first width.

According to an embodiment, an antenna according to the conductive pattern may be configured to operate in a low band (LB), a mid-band (MB), a high band (HB), and an ultra-high band (UHB) for fourth generation (4G) wireless communication and fifth generation (5G) wireless communication. The antenna may be configured to radiate a wireless signal at a first frequency in the low band (LB), as a current is supplied through the first conductive pattern and the third conductive pattern. A wireless signal may be configured to be radiated at a second frequency in the low band (LB), as a current is supplied through the first conductive pattern and the second conductive pattern. The third conductive pattern may have a larger area than an area of the second conductive pattern.

According to an embodiment, a wireless signal may be configured to be radiated in the mid-band (MB) and the high band (HB), as a current is supplied through boundary regions on both sides of the tapering shape of the first conductive pattern. A wireless signal may be configured to be radiated in the ultra-high band (UHB) as a current is supplied through an inner region of the tapering shape of the first conductive pattern.

According to an embodiment, the antenna assembly may further include a printed circuit board (PCB) connected, at the feed point, to the conductive pattern disposed on the front surface of the inner cover, and disposed between the metal frame and the outer cover. The PCB may have a feed pattern disposed thereon to be connected to the feed point of the conductive pattern.

According to an embodiment, the antenna assembly may further include a ground contact portion disposed between the PCB and the metal frame so that the conductive pattern disposed on the one side surface of the inner cover is in contact with the metal frame. The antenna assembly may further include a display module fixed to the metal frame and configured to display screen information. The metal frame may be a display frame configured to support the display module.

According to an embodiment, the antenna assembly may further include a front cover including a front surface, an inner side surface, and an outer side surface, disposed to support the display module through the inner side surface, and configured such that the metal frame and the conductive pattern are placed in a space between the inner side surface and the outer side surface. The slot region disposed between the conductive pattern and the metal frame may be disposed on the inner side surface of the front cover.

According to an embodiment, the antenna assembly may be disposed inside a rear seat monitor module disposed in a rear seat of a vehicle, and performs wireless communication within the vehicle and wireless communication between the vehicle and another vehicle or a wireless entity outside the vehicle.

According to an embodiment, the antenna assembly may further include a first antenna and a second antenna arranged on a left side and a right side of the rear seat monitor module, respectively. The antenna assembly may further include a third antenna and a fourth antenna arranged on an upper left side and an upper right side of the rear seat monitor module, respectively.

According to an embodiment, the first antenna may be positioned in a further left region compared to the third antenna, and the second antenna may be positioned in a further right region compared to the fourth antenna.

According to an embodiment, the antenna assembly may further include a network access device (NAD) disposed on the PCB and coupled to the first antenna to the fourth antenna to control to perform multiple input/output (MIMO) operation through the first antenna to the fourth antenna. The NAD and the first antenna to the fourth antenna may be connected to each other via a coaxial cable.

According to another aspect of the present disclosure, there is also provided an antenna assembly mounted on a vehicle, the antenna assembly including: a display module; an inner cover made of a dielectric material and having a front surface, and one side surface and another side surface each extending from the front surface; a conductive pattern disposed to extend from a feed point on the front surface of the inner cover to the one side surface of the inner cover, the conductive pattern being configured to have a tapering shape from the one side surface toward the feed point on the front surface; a metal frame disposed to surround a rear surface and side surfaces of the display module; a front cover including a front surface, an inner side surface, and an outer side surface, disposed to support the display module through the inner side surface, and configured such that the metal frame and the conductive pattern are disposed in a space between the inner side surface and the outer side surface; and a slot region disposed between the conductive pattern and the metal frame. The conductive pattern may be configured to have a tapering shape from the one side surface toward the feed point on the front surface to transmit or receive a wireless signal.

According to an embodiment, the conductive pattern may extend from both end portions of the one side surface to the front surface to define a first end point and a second end point. The first end point of the conductive pattern may be disposed to be curved toward the feed point and the second end point of the conductive pattern may be disposed to be curved toward the feed point so that the conductive pattern transmits or receives a wideband wireless signal.

According to an embodiment, the antenna assembly may further include an outer cover coupled to the inner cover.

According to an embodiment, the conductive pattern may include: a first conductive pattern configured to have a tapering shape from the one side surface of the inner cover toward the feed point on the front surface of the inner cover; and a second conductive pattern extending from a first end portion of the one side surface to the front surface to define the first end point. The conductive pattern may further include a third conductive pattern extending from a second end portion of the one side surface to the front surface to define the second end point. The first end point of the second conductive pattern may be disposed to be curved toward the feed point, and the second end point of the third conductive pattern may be disposed to be curved toward the feed point.

According to an embodiment, the inner cover may further include an inclined region disposed to be inclined between the front surface and the one side surface. The conductive pattern may include: a first sub-pattern disposed on the front surface of the inner cover to have a tapering shape and having a feed point at an end portion; a second sub-pattern disposed on the inclined region of the inner cover to have a tapering shape; and a third sub-pattern disposed on the one side surface of the inner cover to have a first width and a first length. A distance between points connecting from the second sub-pattern to the third sub-pattern may be configured as a second width smaller than the first width. A distance between points connecting from the first sub-pattern to the second sub-pattern may be configured to as a third width smaller than the second width.

According to an embodiment, The second conductive pattern may be connected to the first sub-pattern in the inclined region of the inner cover, and the first end point may be disposed to be curved inwardly toward the feed point. The third conductive pattern may be connected to the first sub-pattern in the inclined region of the inner cover, and the second end point may be disposed to be curved inwardly toward the feed point.

According to an embodiment, the antenna assembly may further include a printed circuit board (PCB) connected, at the feed point, to the conductive pattern disposed on the front surface of the inner cover, and disposed between the metal frame and the outer cover. The PCB may have a feed pattern disposed thereon to be connected to the feed point of the conductive pattern.

According to an embodiment, The antenna assembly may be disposed inside a rear seat monitor module disposed in a rear seat of a vehicle, and perform wireless communication within the vehicle and wireless communication between the vehicle and another vehicle or a wireless entity outside the vehicle.

According to an embodiment, the antenna assembly may include a first antenna and a second antenna arranged on a left side and a right side of the rear seat monitor module, respectively. The antenna assembly may further include a third antenna and a fourth antenna arranged on an upper left side and an upper right side of the rear seat monitor module, respectively.

According to an embodiment, the first antenna may be positioned in a further left region compared to the third antenna, and the second antenna may be positioned in a further right region compared to the fourth antenna.

According to an embodiment, a processor of the antenna assembly may perform 2X2 multiple input/output (MIMO) operation in the low band (LB) through the first antenna and the second antenna. The processor may perform up to 4X4 MIMO operation in the mid-band (MB), the high band (HB), and the ultra-high band (UHB) through the first antenna to the fourth antenna 1100d.

### Advantageous Effects of Invention

The technical effects of such an antenna assembly having a wideband antenna mounted in a vehicle and the vehicle in which the antenna assembly is mounted will be described as follows.

According to the present disclosure, an antenna assembly in which a plurality of antennas for fourth generation (4G)/fifth generation (5G) communication are arranged through a slot structure in a module having a metal frame disposed therein may be placed in a vehicle.

According to the present disclosure, an antenna element operating as a radiator in a wide band such as a mid-band (MB), a high band (HB), and an ultra-high band (UHB) for 4G/5G communications may be implemented by configuring an antenna pattern operating in a slot structure and by a dual mode.

According to the present disclosure, a radiator structure for improving antenna characteristics in the low band (LB) may be configured through a radiator structure in a dual mode using a dual feed method

According to the present disclosure, 4G/5G wireless communication may be provided in a vehicle by disposing at least one antenna element in an inner cover made of a dielectric material and defining a slot structure with a peripheral metal frame inside a monitor structure installed in a rear seat of a vehicle.

According to the present disclosure, as antenna elements are arranged on one side and another side within a limited region of an antenna assembly having a monitor structure, an antenna arrangement structure for minimizing an interference between the antenna elements may be provided.

According to the present disclosure, as antenna element are arranged on a left side and a right side in a limited region of an antenna assembly, an antenna arrangement structure for minimizing an interference between the antenna elements may be provided.

Another object of the present disclosure is to provide a structure for mounting an antenna assembly capable of operating in a wide band to support various communication systems inside a rear seat monitor structure of a vehicle.

Further scope of applicability of the present disclosure will become apparent from the foregoing detailed description. It should be understood, however, that the detailed description and specific examples, such as the preferred embodiment of the present disclosure, are given by way of illustration only, since various modifications and alternations within the spirit and scope of the disclosure will be apparent to those skilled in the art.

### Brief Description of Drawings

FIG. 1A is a diagram illustrating an internal configuration of a vehicle in accordance with one example. FIG. 1B is a lateral view illustrating the vehicle interior in accordance with the one example.
FIG. 2A illustrates types of vehicle-to-everything (V2X) applications.
FIG. 2B illustrates a standalone scenario supporting V2X sidelink (SL) communication and a multi-radio dual connectivity (MR-DC) scenario supporting V2X SL communication.
FIGS. 3A to 3C are views illustrating a structure for mounting an antenna system in a vehicle, to which the antenna system is mounted.
FIG. 4 is a block diagram illustrating a vehicle and an antenna system mounted to the vehicle in accordance with one example.
FIG. 5A is a conceptual diagram related to an operating band and a structure of a radiator structure of a wideband antenna module for a vehicle according to the present disclosure.
FIG. 5B illustrates a structure in which the radiator structure of FIG. 5A is placed in a frame. FIG. 5C illustrates a structure in which the radiator structure of FIG. 5B is disposed in a dielectric structure.
FIG. 6A illustrates a structure in which the wideband antenna module is placed in a rear seat of the vehicle.
FIG. 6B illustrates antenna characteristics in a low band (LB) and a high band (HB) when a matching circuit is disposed in a feeding portion in the antenna structure of FIG. 5C.
FIG. 6C is a conceptual diagram illustrating a principle in which wideband characteristics is implemented by a conductive pattern having a tapering shape included in the antenna structure of FIG. 5C.
FIG. 7 is an exploded view of an antenna assembly for a vehicle in which a plurality of antenna modules are disposed in a rear seat of the vehicle according to the present disclosure.
FIGS. 8A and 8B illustrate side views of an antenna assembly according to embodiments.
FIG. 9A shows reflection coefficient characteristics for the radiator structure of FIG. 5B. FIG. 9B shows a current distribution in each frequency band for the radiator structure of FIG. 5B.
FIG. 10 illustrates a structure in which a plurality of antennas arranged in different regions of a printed circuit board (PCB) included in the antenna assembly according to the present disclosure are connected to a network access device (NAD).
FIG. 11 illustrates various structures in which a location where a feed pattern is connected to a conductive pattern is changed.
FIG. 12 illustrates various structures in which a gap between the conductive pattern and the feed pattern is changed.
FIG. 13 shows a voltage standing wave ratio (VSWR) result according to a change in radiator structures of FIGS. 11 and 12.
FIG. 14 shows radiator structures in which a delay line is arranged on another side of the conductive pattern.
FIG. 15 shows a VSWR results according to radiator structures of FIG. 14.
FIG. 16A shows a structure in which first and second delay lines are connected to a conductive pattern of a pattern integrated slot antenna (PISA) structure.
FIG. 16B shows a process in which a first conductive pattern having a tapering shape is disposed in a slot region of the PISA structure of FIG. 16A to constitute the radiator structure of FIG. 5B and 5C.
FIG. 17 illustrates structures in which a height from a metal frame to a conductive pattern is changed in the radiator structure according to the present disclosure.
FIGS. 18A to 18C illustrate antenna characteristics according to a change in a height from the metal frame to the conductive pattern each shown in FIG. 17.
FIG. 19 shows structures in which a gap from a metal frame to a conductive pattern or a front cover is changed according to embodiments.
FIG. 20 shows antenna radiation characteristics according to a change in a gap from the metal frame to the conductive pattern each shown in FIG. 19.
FIGS. 21A and 21B show gain characteristics of first to fourth antennas of FIG. 10.
FIG. 22 is a block diagram illustrating an antenna module according to an embodiment and a vehicle on which the antenna module is mounted.

### Mode for the Invention

A description will now be given in detail according to exemplary embodiments disclosed herein, with reference to the accompanying drawings. For the sake of a brief description with reference to the drawings, the same or equivalent components may be provided with the same or similar reference numbers, and the description thereof will not be repeated. A suffix "module" or "unit" used for elements disclosed in the following description is merely intended for easy description of the specification, and the suffix itself is not intended to give any special meaning or function. In describing the disclosure, if a detailed explanation for a related known function or construction is considered to unnecessarily divert the gist of the disclosure, such explanation has been omitted but would be understood by those skilled in the art. The accompanying drawings are used to help easily understand the technical idea of the disclosure and it should be understood that the idea of the disclosure is not limited by the accompanying drawings. The idea of the disclosure should be construed to extend to any alterations, equivalents, and substitutes besides the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element may be connected with the another element or intervening elements may also be present. In contrast, when an element is referred to as being "directly connected with" another element, there are no intervening elements present.

A singular representation may include a plural representation unless it represents a definitely different meaning from the context.

Terms "include" or "has" as used herein should be understood that they are intended to indicate the existence of a feature, a number, a step, an element, a component or a combination thereof disclosed in the specification, and it may also be understood that the existence or additional possibility of one or more other features, numbers, steps, elements, components or combinations thereof are not excluded in advance.

An antenna system described herein may be mounted on a vehicle. Configurations and operations according to embodiments may also be applied to a communication system, namely, an antenna system mounted on a vehicle. In this regard, the antenna system mounted on the vehicle may include a plurality of antennas, and a transceiver circuitry and a processor that control the plurality of antennas.

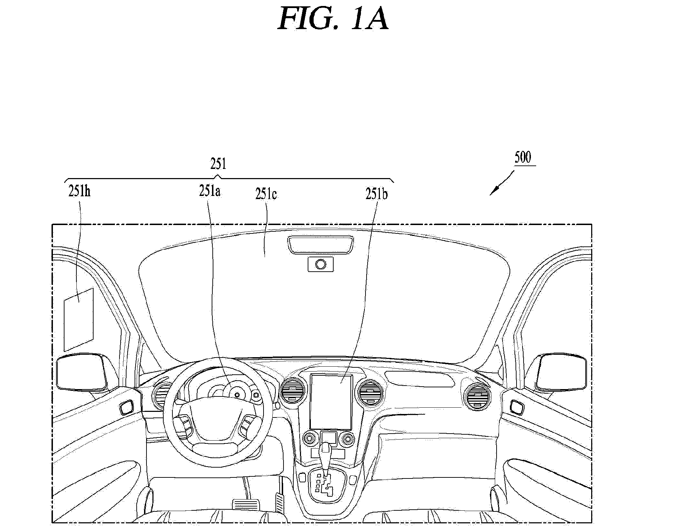

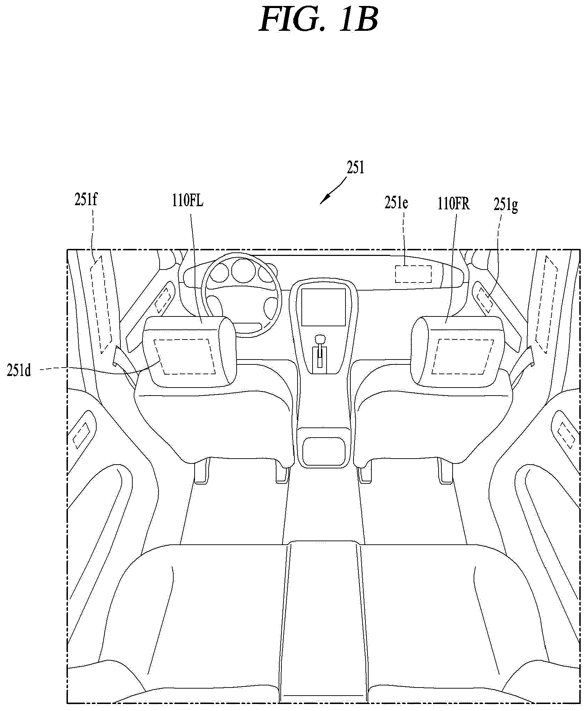

FIGS. 1A and 1B are diagrams illustrating the interior of the vehicle. As illustrated in FIGS. 1A and 1B, the present disclosure relates to a vehicle having an antenna unit capable of transmitting and receiving signals through GPS, 4G wireless communication, 5G wireless communication, Bluetooth, or wireless LAN. Therefore, the antenna unit (i.e., the antenna system) capable of supporting these various communication protocols may be referred to as an integrated antenna module. The present disclosure also describes a vehicle 500 having the antenna system. In this regard, the antenna assembly may be disposed on glass of the vehicle 500 or on a display inside the vehicle.

The display 251 may output graphic objects corresponding to various types of information. The display 251 may include at least one of a liquid crystal display (LCD), a thin film transistor-liquid crystal display (TFT-LCD), an organic light-emitting diode (OLED), a flexible display, a 3-dimensional (3D) display, and an e-ink display.

The display 251 may have an inter-layered structure or an integrated structure with a touch input unit to implement a touch screen. The display 251 may be implemented as a head-up display (HUD). When the display 251 is implemented as the HUD, the display 251 may be provided with a projecting module to output information through an image which is projected on a windshield or a window.

The display 251 may include a transparent display. The transparent display may be attached to the windshield or the window. The transparent display may have a predetermined degree of transparency and output a predetermined screen thereon. The transparent display may include at least one of a transparent thin film electroluminescent (TFEL), a transparent organic light-emitting diode (OLED), a transparent liquid crystal display (LCD), a transmissive transparent display, and a transparent LED display. The transparent display may have adjustable transparency.

The glass of the vehicle 500 or the display inside the vehicle may include one or more of displays 251a to 251g. The display 251 may be disposed on one area of a steering wheel, one area 521a, 251b, 251e of an instrument panel, one area 251d of a seat, one area 251f of each pillar, one area 251g of a door, one area of a center console, one area of a headlining or one area of a sun visor, or implemented on one area 251c of a windshield or one area 251h of a window.

In addition, the antenna system according to the present disclosure may be disposed in seats 110FL and 110FR of the vehicle. The antenna system according to the present disclosure may be disposed in one area of the seats 110FL and 110FR of a vehicle, for example, in a display 251d in a rear seat of the vehicle. In relation to this, the antenna system according to the present disclosure may be implemented in the display 251d in the rear seat of the vehicle or in a structure supporting the display 251d.

### <V2X (Vehicle-to-Everything)>

Vehicle-to-everything (V2X) communication includes communication between a vehicle and each of all entities, such as vehicle-to-vehicle (V2V) communication which refers to communication between vehicles, vehicle-to-Infrastructure (V2I) communication which refers to communication between a vehicle and an eNB or a road side unit (RSU), vehicle-to-pedestrian (V2P) communication which refers to communication between a vehicle and a terminal carried by a person (a pedestrian, a cyclist, a vehicle driver, or a passenger), vehicle-to-network (V2N) communication, and the like.

V2X communication may have the same meaning as V2X sidelink or NR V2X or may have, in a broader sense, a meaning including V2X sidelink or NR V2X.

V2X communication may be applicable to various services, for example, forward collision warning, an automatic parking assist system, cooperative adaptive cruise control (CACC), control-loss warning, traffic queuing warning, traffic vulnerable-area safety warning, emergency vehicle warning, curved-road driving speed warning, and traffic flow control.

V2X communication may be provided through a PC5 interface and/or a Uu interface. In this case, specific network entities for supporting communications between a vehicle and all entities may exist in a wireless communication system supporting V2X communication. For example, the network entity may include a base station (eNB), a road side unit (RSU), a terminal, or an application server (e.g., a traffic safety server).

In addition, a terminal performing V2X communication may refer to not only a general handheld UE but also a vehicle UE (V-UE), a pedestrian UE, an eNB type RSU, a UE type RSU, a robot equipped with a communication module, and the like.

V2X communication may be performed directly between terminals or may be performed through the network entity (entities). V2X operation modes may be classified according to a method of performing such V2X communication.

Terms used in V2X communication may be defined as follows.

A road side unit (RSU) is a V2X service enabled device that may transmit and receive data to and from a moving vehicle using a V2I service. The RSU also serves as a stationary infrastructure entity that supports V2X application programs, and may exchange messages with other entities that support V2X application programs. The RSU is a term frequently used in existing ITS specifications, and the reason for employing the term RSU in association with the 3GPP specifications is to read relevant documents in an easier manner in the ITS industry. The RSU is a logical entity that combines a V2X application logic with the functionality of an eNB (referred to as an eNB-type RSU) or a UE (referred to as a UE-type RSU).

A V2I Service is a type of V2X service, where one party is a vehicle whereas the other party is an entity belonging to an infrastructure. A V2P Service is also a type of V2X service, where one party is a vehicle and the other party is a device carried by a person (e.g., a portable terminal carried by a pedestrian, a cyclist, a driver, or an occupant other than a driver). A V2X Service is a type of 3GPP communication service that involves a transmitting or receiving device on a vehicle. Based on the other party involved in the communication, it may be further divided into V2V service, V2I service, and V2P service.

A V2X-enabled UE is a UE that supports the V2X service. A V2V Service is a type of V2X service, where both parties involved in communication are vehicles. A V2V communication range is a direct communication range between two vehicles involved in the V2V service.

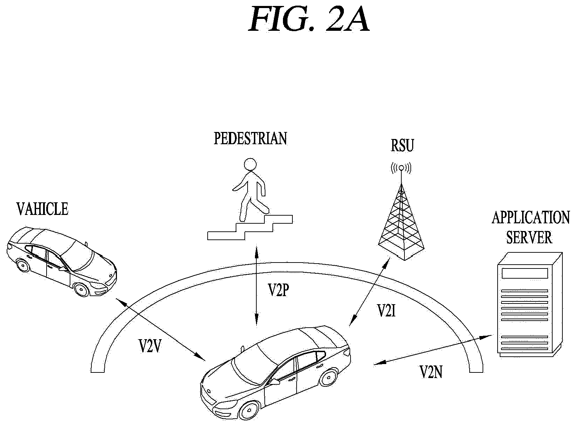

V2X applications, referred to as vehicle-to-everything (V2X), may include the four different types, as described above, namely, (1) vehicle-to-vehicle (V2V), (2) vehicle-to-infrastructure (V2I), (3) vehicle-to-network (V2N), and (4) vehicle-to-pedestrian (V2P). FIG. 2A illustrates types of V2X applications. Referring to FIG. 2A, the four types of V2X applications may use "cooperative awareness" to provide more intelligent services for end-users.

This means that, in order to provide more intelligent information, such as cooperative collision warning or autonomous traveling, entities, such as vehicles, roadside-based facilities, application servers, and pedestrians, may collect knowledge of involved local environments (e.g., information received from nearby vehicles or sensor equipment) to process and share the corresponding knowledge.

### <NR V2X>

In 3GPP Releases 14 and 15, support of the V2V and V2X services in LTE has been introduced to extend the 3GPP platform to the automotive industry.

Requirements for support of enhanced V2X use cases are largely organized into four use case groups.
(1) Vehicles platooning enables the vehicles to dynamically form a platoon traveling together. All the vehicles in the platoon obtain information from the leading vehicle to manage this platoon. This information allows the vehicles to drive closer than normal in a coordinated manner, going in the same direction and traveling together.
(2) Extended sensors enable the exchange of raw or processed data gathered through local sensors or live video images among vehicles, road site units, devices of pedestrians and V2X application servers. The vehicle may recognize an environment much more than through detection by its sensor and may recognize a local situation as a whole in a more extensive manner. A high data transmission rate is one of primarily features of the extended sensor.
(3) Advanced driving enables semi-automatic or fully-automatic driving. The advanced driving enables each vehicle and/or each RSU to share self-recognition data obtained from a local sensor with a nearby vehicle and to synchronize and adjust a trajectory or a maneuver. Each vehicle shares its intention to drive with a nearby vehicle.
(4) Remote driving enables a remote driver or a V2X application to operate a remote vehicle for those occupants who cannot drive by themselves or remote vehicles located in dangerous environments. Cloud computing-based driving may be used in the case where fluctuation is limited and a path is predictable like public transportation. High reliability and low latency are key requirements for the remote driving.

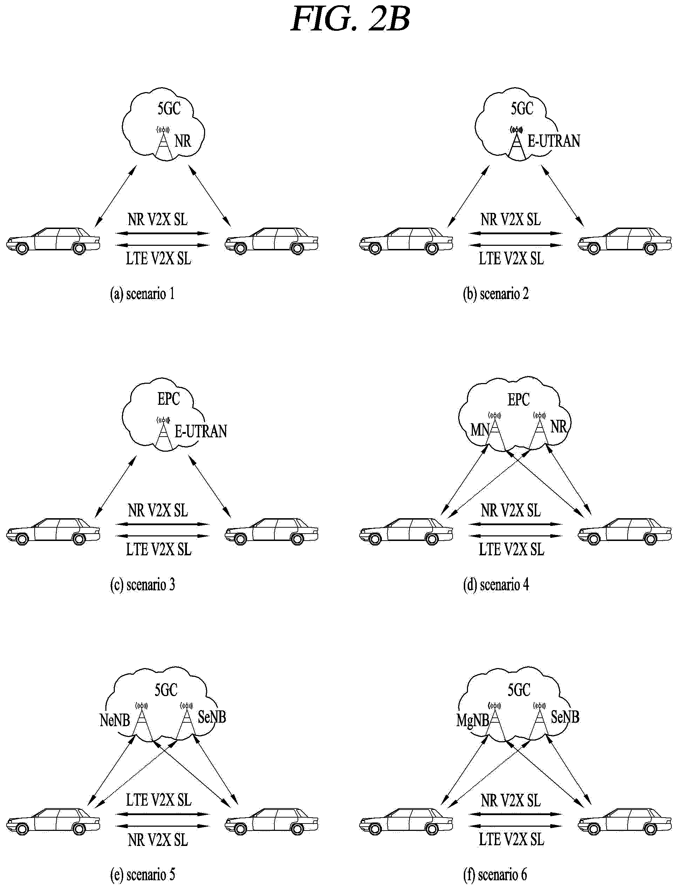

The following description may be applicable to both NR sidelink (SL) and LTE SL, and may denote NR SL when no radio access technology (RAT) is indicated. Six operational scenarios may be considered in NR V2X as follows. In this regard, FIG. 2B illustrates a standalone scenario supporting V2X SL communication and an MR-DC scenario supporting V2X SL communication.

In particular, 1) in Scenario 1, gNB provides control/configuration for V2X communication of a UE in both LTE SL and NR SL. 2) In Scenario 2, ng-eNB provides control/configuration for V2X communication of the UE in both LTE SL and NR SL. 3) In Scenario 3, eNB provides control/configuration for UE's V2X communication in both LTE SL and NR SL. On the other hand, 4) in Scenario 4, V2X communication of the UE in LTE SL and NR SL is controlled/configured by Uu while the UE is configured with Evolved-Universal Terrestrial Radio Access-New Radio Dual Connectivity (EN-DC). 5) In Scenario 5, V2X communication of the UE in LTE SL and NR SL is controlled/configured by Uu while the UE is configured in NR-E-UTRA Dual Connectivity (NE-DC). 6) In Scenario 6, V2X communication of the UE in LTE SL and NR SL is controlled/configured by Uu while the UE is configured with NG-RAN-E-UTRA UTRA Dual Connectivity (NGEN-DC).

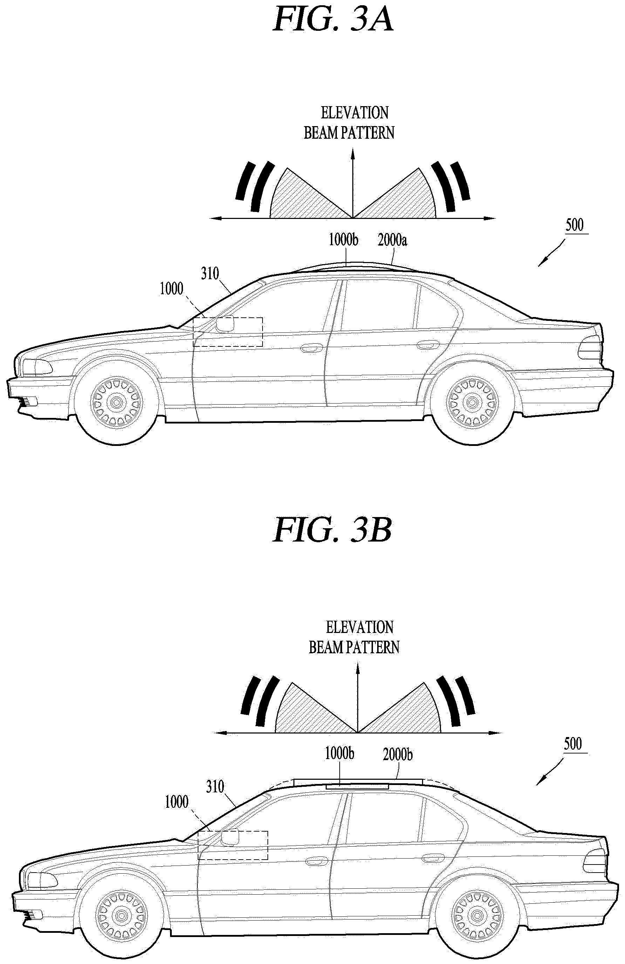

In order to support the V2X communication, as illustrated in FIGS. 2A and 2B, the vehicle may perform wireless communication with eNB and/or gNB through an antenna system. The antenna system may be configured as an internal antenna system as illustrated in FIGS. 1A and 1B. The antenna system may alternatively be implemented as an external antenna system and/or an internal antenna system as illustrated in FIGS. 3A to 3C.

FIGS. 3A to 3C are views illustrating an example of a structure for mounting an antenna system on a vehicle, which includes the antenna system mounted on the vehicle. In this regard, FIGS. 3A to 3C illustrate a configuration capable of performing wireless communication through a transparent antenna disposed on the front window 310 of the vehicle. An antenna system 1000 including a transparent antenna may be disposed on a front window of a vehicle and inside the vehicle. Wireless communication may also be performed through a transparent antenna disposed on side glass of the vehicle, in addition to the front window.

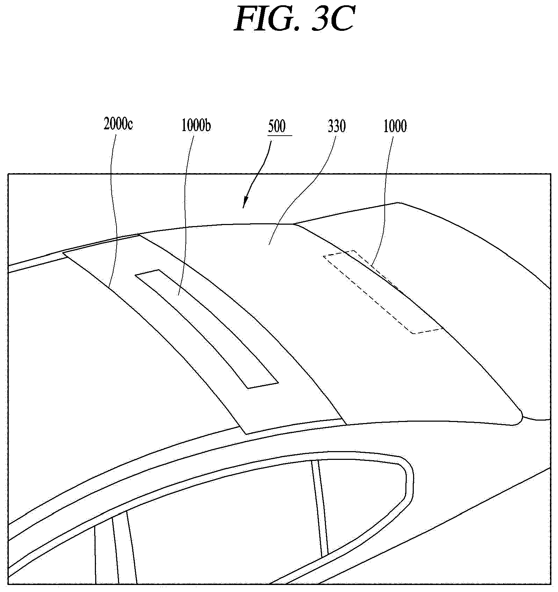

The antenna system for the vehicle that includes the transparent antenna may be combined with other antennas. Referring to FIGS. 3A to 3C, in addition to the antenna system 1000 implemented as the glass or display, a separate antenna system 1000b may be further configured. FIGS. 3A and 3B illustrate a structure in which the antenna system 1000b, in addition to the antenna system 1000, is mounted on or in a roof of the vehicle. On the other hand, FIG. 3C illustrates a structure in which the separate antenna system 1000b, in addition to the antenna system 1000, is mounted in a roof of the vehicle or a roof frame of a rear mirror of the vehicle.

Referring to FIGS. 3A to 3C, to improve the appearance of the vehicle and to maintain a telematics performance at the time of collision, an existing shark fin antenna may be replaced with a flat antenna of a non-protruding shape. In addition, the present disclosure proposes an integrated antenna of an LTE antenna and a 5G antenna considering fifth generation (5G) communication while providing the existing mobile communication service (e.g., LTE).

Referring to FIG. 3A, the antenna system 1000 implemented as the glass or display may be disposed on the front window 310 of the vehicle or an inner display of the vehicle. The second antenna system 1000b corresponding to an external antenna may be disposed on the roof of the vehicle. In FIG. 3A, a radome 2000a may cover the second antenna system 1000b to protect the second antenna system 1000b from an external environment and external impacts while the vehicle travels. The radome 2000a may be made of a dielectric material through which radio signals are transmitted/received between the second antenna system 1000b and a base station.

Referring to FIG. 3B, the antenna system 1000 implemented as the glass or display may be disposed on the front window 310 of the vehicle or an inner display of the vehicle. In some embodiments, the second antenna system 1000b corresponding to the external antenna may be disposed within a roof structure of the vehicle and at least part of the roof structure may be made of a non-metallic material. In this instance, the roof structure 2000b of the vehicle except for the at least part made of the non-metallic material may be made of a dielectric material through which radio signals are transmitted/received between the antenna system 1000b and the base station.

Referring to FIG. 3C, the antenna system 1000 implemented as the glass or display may be disposed on a rear window 330 of the vehicle or the inner display of the vehicle. The second antenna system 1000b corresponding to the external antenna may be disposed within a roof frame 2000c of the vehicle, and at least part of the roof frame 2000c may be made of a non-metallic material.in this instance, the roof frame 2000c of the vehicle 500 except for the at least part made of the non-metallic material may be made of a dielectric material through which radio signals are transmitted/received between the second antenna system 1000b and the base station.

Referring to FIGS. 3A to 3C, antennas provided in the antenna system 1000 mounted on the vehicle may form a beam pattern in a direction perpendicular to the front window 310 or the rear window 330. Antennas provided in the second antenna system 1000 mounted on the vehicle may further define a beam coverage by a predetermined angle in a horizontal region with respect to the vehicle body.

Meanwhile, the vehicle 500 may include only the antenna unit (i.e., the internal antenna system) 1000 corresponding to the internal antenna without the antenna system 1000b corresponding to the external antenna.

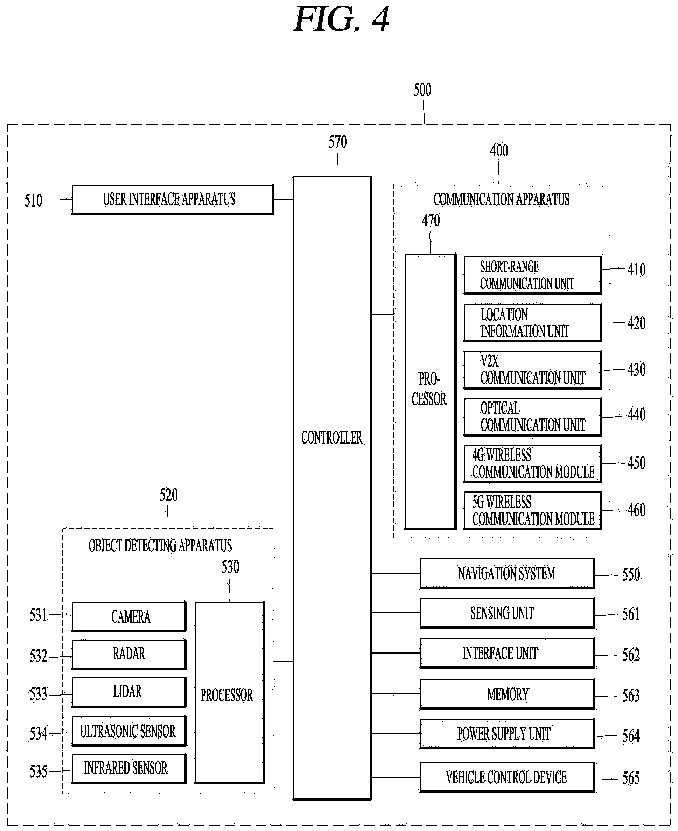

Meanwhile, FIG. 4 is a block diagram illustrating a vehicle and an antenna system mounted on the vehicle in accordance with an implementation.

The vehicle 500 may be an autonomous (driving) vehicle. The vehicle 500 may be switched into an autonomous driving mode or a manual mode (a pseudo driving mode) based on a user input. For example, the vehicle 500 may be switched from the manual mode into the autonomous mode or from the autonomous mode into the manual mode based on a user input received through a user interface device 510.

In relation to the manual mode and the autonomous driving mode, operations such as object detection, wireless communication, navigation, and operations of vehicle sensors and interfaces may be performed by the telematics control unit mounted on the vehicle 500. Specifically, the telematics control unit mounted on the vehicle 500 may perform the operations in cooperation with an antenna module 300, an object detection apparatus 520, and other interfaces. In some examples, a communication device 400 may be disposed in the telematics control unit separately from the antenna system 300 or may be disposed in the antenna system 300.

The vehicle 500 may be switched into the autonomous mode or the manual mode based on driving environment information. The driving environment information may be generated based on object information provided by the object detection apparatus 520. For example, the vehicle 500 may be switched from the manual mode into the autonomous driving mode or from the autonomous driving mode into the manual mode based on driving environment information generated in the object detection apparatus 520.

For example, the vehicle 500 may be switched from the manual mode into the autonomous driving mode or from the autonomous driving mode into the manual mode based on driving environment information received through the communication device 400. The vehicle 500 may be switched from the manual mode into the autonomous mode or from the autonomous module into the manual mode based on information, data, or signal provided from an external device.

When the vehicle 500 is driven in the autonomous driving mode, the autonomous vehicle 500 may be driven based on an operation system. For example, the autonomous vehicle 500 may travel based on information, data, or signal generated in a driving system, a parking-lot departure system, or a parking-lot entrance system. When the vehicle 500 runs in the manual mode, the autonomous vehicle 500 may receive user input for driving through a driving operation apparatus. The vehicle 500 may travel based on the user input received through a driving operation apparatus.

The vehicle 500 may include a user interface device 510, an object detection device 520, a navigation system 550, and a communication device 400. The vehicle may further include a sensing unit 561, an interface unit 562, a memory 563, a power supply unit 564, and a vehicle control device 565 in addition to the aforementioned apparatuses and devices. According to embodiments the vehicle 500 may include more components in addition to components described herein or may not include some of those components described herein.

The user interface device 510 may be a device for communication between the vehicle 500 and a user. The user interface device 510 may receive user input and provide information generated in the vehicle 500 to the user. The vehicle 500 may implement user interfaces (Uls) or user experiences (UXs) through the user interface device 510.

The object detection device 520 may be a device for detecting an object located at outside of the vehicle 500. The object may be a variety of things associated with operations of the vehicle 500. In some examples, objects may be classified into moving objects and fixed (stationary) objects. For example, the moving objects may include other vehicles and pedestrians. The fixed objects may conceptually include, for example, traffic signals, roads, and structures. The object detection device 520 may include a camera 521, a radar 522, a LiDAR 523, an ultrasonic sensor 524, an infrared sensor 525, and a processor 530. According to an embodiment, the object detection device 520 may further include other components in addition to the components described, or may not include some of the components described.

The processor 530 may control an overall operation of each unit of the object detection device 520. The processor 530 may detect an object based on an acquired image, and track the object. The processor 530 may execute operations, such as computing a distance to the object, computing a relative speed to the object and the like, through an image processing algorithm.

According to an embodiment, the object detection device 520 may include a plurality of processors 530 or may not include any processor 530. For example, each of the camera 521, the radar 522, the LiDAR 523, the ultrasonic sensor 524, and the infrared sensor 525 may include the processor individually.

When the processor 530 is not included in the object detection device 520, the object detection device 520 may operate according to the control of a processor of an apparatus within the vehicle 500 or a controller 570.

The navigation system 550 may provide location information related to the vehicle based on information obtained through the communication device 400, in particular, a location information unit 420. Also, the navigation system 550 may provide a path (or route) guidance service to a destination based on current location information related to the vehicle. In addition, the navigation system 550 may provide guidance information related to the surrounding locations of the vehicle based on information obtained through the object detection device 520 and/or a V2X communication unit 430. In some examples, guidance information, autonomous driving service, etc. may be provided based on V2V, V2I, and V2X information obtained through a wireless communication unit 460 which operates together with the antenna system 1000.

The communication device 400 may be a device3 for performing communication with an external device. Here, the external device may be another vehicle, a mobile terminal, or a server. The communication device 400 may perform the communication by including at least one of a transmitting antenna, a receiving antenna, a radio frequency (RF) circuit, and an RF device for implementing various communication protocols. The communication device 400 may include a short-range communication unit 410, a location information unit 420, a V2X communication unit 430, an optical communication unit 440, a broadcast transceiver 450, and a processor 470. According to an embodiment, the communication device 400 may further include other components in addition to the components described, or may not include some of the components described.

The short-range communication unit 410 is a unit for facilitating short-range communications. The short-range communication unit 410 may construct short-range wireless area networks to perform short-range communication between the vehicle 500 and at least one external device. The location information unit 420 may be a unit for acquiring location information related to the vehicle 500. For example, the location information unit 420 may include a global positioning system (GPS) module or a differential global positioning system (DGPS) module.

The V2X communication unit 430 may be a unit for performing wireless communications with a server (vehicle to infrastructure; V2I), another vehicle (vehicle to vehicle; V2V), or a pedestrian (vehicle to pedestrian; V2P). The V2X communication unit 430 may include an RF circuit in which protocols for communication with an infrastructure (V21), communication between vehicles (V2V), and communication with a pedestrian (V2P) are executable. The optical communication unit 440 may be a unit for performing communication with an external device through the medium of light. The optical communication unit 440 may include an optical transmission part for converting an electric signal into an optical signal and transmitting the optical signal to the outside, and an optical reception part for converting the received optical signal into the electric signal. According to an embodiment, the optical transmission part may be formed integrally with lamps provided on the vehicle 500.

A wireless communication unit 460 may be a unit that performs wireless communication with one or more communication systems through one or more antenna systems. The wireless communication unit 460 may transmit and/or receive a signal to and/or from a device in a first communication system through a first antenna system. In addition, the wireless communication unit 460 may transmit and/or receive a signal to and/or from a device in a second communication system through a second antenna system. For example, the first communication system and the second communication system may be an LTE communication system and a 5G communication system, respectively. However, the first communication system and the second communication system may not be limited thereto, and may be changed according to applications.

In some examples, the antenna module 300 disposed in the vehicle 500 may include a wireless communication unit. In this regard, the vehicle 500 may be an electric vehicle (EV) or a vehicle that is accessible to a communication system independently of an external electronic device. In this regard, the communication device 400 may include at least one of the short-range communication unit 410, the location information unit 420, the V2X communication unit 430, the optical communication unit 440, a 4G wireless communication module 450, and a 5G wireless communication module 460.

The 4G wireless communication module 450 may perform transmission and reception of 4G signals with a 4G base station through a 4G mobile communication network. In this instance, the 4G wireless communication module 450 may transmit at least one 4G transmission signal to the 4G base station. In addition, the 4G wireless communication module 450 may receive at least one 4G reception signal from the 4G base station. In this regard, uplink (UL) Multi-input/Multi-output (MIMO) may be performed by a plurality of 4G transmission signals transmitted to the 4G base station. In addition, downlink (DL) MIMO may be performed by a plurality of 4G reception signals received from the 4G base station.

The 5G wireless communication module 460 may perform transmission and reception of 5G signals with a 5G base station through a 5G mobile communication network. Here, the 4G base station and the 5G base station may have a non-stand-alone (NSA) architecture. The 4G base station and the 5G base station may be disposed in the non-stand-alone (NSA) architecture. Alternatively, the 5G base station may be disposed in a stand-alone (SA) architecture at a separate location from the 4G base station. The 5G wireless communication module 460 may perform transmission and reception of 5G signals with a 5G base station through a 5G mobile communication network. In this case, the 5G wireless communication module 460 may transmit at least one 5G transmission signal to the 5G base station. In addition, the 5G wireless communication module 460 may receive at least one 5G reception signal from the 5G base station. In this instance, a 5G frequency band that is the same as a 4G frequency band may be used, and this may be referred to as LTE re-farming. In some examples, a Sub6 frequency band, which is a range of 6 GHz or less, may be used as the 5G frequency band. In contrast, a millimeter-wave (mmWave) band may be used as the 5G frequency band to perform wideband high-speed communication. When the mmWave band is used, the electronic device may perform beamforming for coverage expansion of an area where communication with a base station is possible.

Regardless of the 5G frequency band, in the 5G communication system, MIMO may be supported to be performed a plurality of times, to improve a transmission rate. In this instance, UL MIMO may be performed by a plurality of 5G transmission signals that are transmitted to a 5G base station. In addition, DL MIMO may be performed by a plurality of 5G reception signals received from the 5G base station.

In some examples, a state of dual connectivity (DC) with both the 4G base station and the 5G base station may be attained through the 4G wireless communication module 450 and the 5G wireless communication module 460. As such, the dual connectivity with the 4G base station and the 5G base station may be referred to as EUTRAN NR DC (EN-DC). In some examples, when the 4G base station and 5G base station are disposed in a co-located structure, throughput improvement may be achieved by inter-carrier aggregation (inter-CA). Accordingly, when the 4G base station and the 5G base station are disposed in the EN-DC state, the 4G reception signal and the 5G reception signal may be simultaneously received through the 4G wireless communication module 450 and the 5G wireless communication module 460. Short-range communication between electronic devices (e.g., vehicles) may be performed using the 4G wireless communication module 450 and the 5G wireless communication module 460. In one embodiment, after resources are allocated, vehicles may perform wireless communication in a V2V manner without a base station.

Meanwhile, for transmission rate improvement and communication system convergence, carrier aggregation (CA) may be carried out using at least one of the 4G wireless communication module 450 and the 5G wireless communication module 460 and a WiFi communication module 113. In this regard, 4G + WiFi carrier aggregation (CA) may be performed using the 4G wireless communication module 450 and the WiFi communication module 113. Or, 5G + WiFi CA may be performed using the 5G wireless communication module 460 and the WiFi communication module.

In some examples, the communication device 400 may implement a display device for a vehicle together with the user interface device 510. In this instance, the display device for the vehicle may be referred to as a telematics apparatus or an audio video navigation (AVN) apparatus.

The processor 470 of the communication device 400 may correspond to a modem. In this regard, an RFIC and the modem may be referred to as a first controller (or a first processor) and a second controller (a second processor), respectively. Meanwhile, the RFIC and the modem may be implemented as physically separate circuits. Alternatively, the RFIC and the modem may be logically or functionally separated from each other on one physical circuit. The modem may perform control and signal processing for signal transmission and reception through different communication systems using the RFID. The modem 1400 may acquire control information from a 4G base station and/or a 5G base station. Here, the control information may be received through a physical downlink control channel (PDCCH), but is not limited thereto.

The modem may control the RFIC 1250 to transmit and/or receive signals through the first communication system and/or the second communication system for a specific time interval and from frequency resources. Accordingly, the vehicle may be allocated resources or maintain a connected state through the eNB or gNB. In addition, the vehicle may perform at least one of V2V communication, V21 communication, and V2P communication with other entities using the allocated resources.

Meanwhile, referring to FIGS. 1A to 4, an antenna module mounted in a vehicle may be placed outside and/or inside the vehicle. When placed inside the vehicle, the antenna module may be disposed on glass or a display of the vehicle. In this regard, the antenna system disclosed herein may be configured to operate in a low band (LB), a mid band (MB), and a high band (HB) of a 4G/LTE system and a Sub6 band of a 5G/NR system.

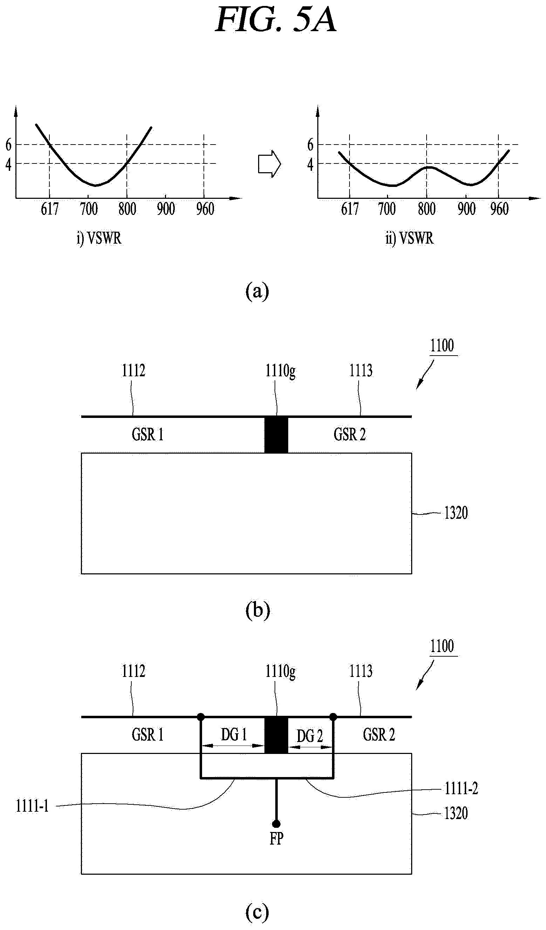

Hereinafter, a wideband antenna structure for a vehicle according to the present disclosure is described. In relation to this, FIG. 5A is a conceptual diagram related to an operating band and a structure of a radiator structure of a wideband antenna module for a vehicle according to the present disclosure.

Referring to (a) of FIG. 5A, an antenna needs to operate in a 617 MHz to 6 GHz band to support 4G wireless communication and 5G wireless communication in the 5G Sub6 band in a vehicle. As an antenna technology for securing such a wide frequency band, the present disclosure proposes an antenna structure having a dual slot structure as shown in FIG. (b) of 5A and an antenna structure fed by a feed line in a form of a delay line as shown in (c) of FIG. 5A.

In relation to this, when a single feeding structure is applied to a dual slot antenna structure of (b) of FIG. 5A, an operating bandwidth of about 230 MHz, from 670 MHz to 800 MHz in the LB, like (i) a voltage standing wave ratio (VSWR) result of (a) of FIG. 5A, may be secured. On the other hand, a dual feeding structure in a form of first and second delay lines 1111-1 and 1111-2 may be applied to a structure of dual slots GSR1 and GSR2 of (c) of FIG. 5A. The first and second delay lines 1111-1 and 1111-2 may be disposed to be apart from a ground contact portion 1110g by predetermined gaps DG1 and DG2. Accordingly, like (ii) a VSWR result of (a) of FIG. 5A, an operating bandwidth of about 350 MHz from 617 MHz to 960 MHz in the LB may be secured.

Referring to (b) of FIG. 5A, a frame 1320 made of a metal material may be connected to a conductive pattern 1110 by the ground contact portion 1110g. First and second slot regions GSR1 and GSR2 may be disposed between the conductive pattern 1110 and the metal frame 1320. A frequency band from 1.4 GHz to 6 GHz may be secured through a wideband antenna having a structure as shown in (b) of FIG. 5A. However, antenna characteristics in the LB corresponding to approximately 350 MHz from 617 MHz to 960 MHz below 1 GHz may not be easily secured.

In relation to this, an operating bandwidth of approximately 230 MHz in the LB with reference to a VSWR of 4 to 1 may be implemented by a single resonant mode of a single feeding structure. Therefore, an additional operating bandwidth of approximately 120 MHz is needed to secure antenna characteristics of the LB corresponding to approximately 350 MHz. Accordingly, in the wideband antenna structure according to the present disclosure, a resonant mode of an antenna may be additionally generated in a limited space to increase an operating bandwidth in the LB without having to increase an additional antenna space.

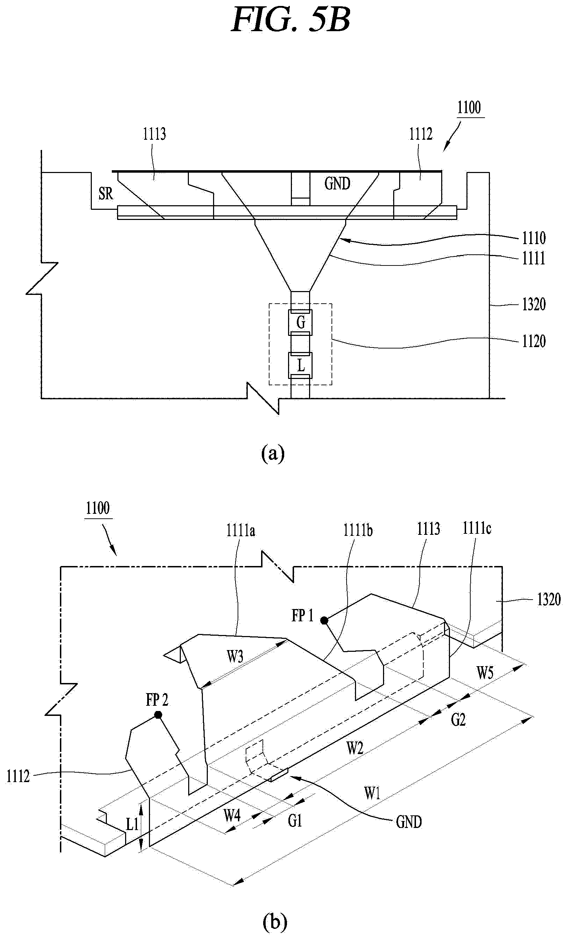

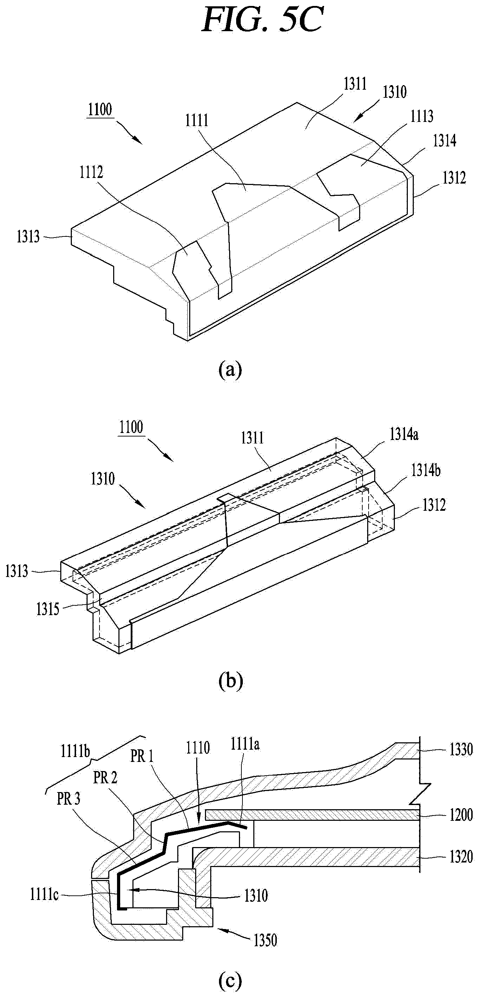

FIG. 5B illustrates a structure in which the radiator structure of FIG. 5A is arranged in a frame. FIG. 5C illustrates a structure in which the radiator structure of FIG. 5B is disposed in a dielectric structure.

The first and second delay lines 1111-1 and 1111-2 of FIG. 5A may be implemented with the conductive pattern 1110 filled internally as shown in FIG. 5B. (a) of FIG. 5B is a front view of the wideband antenna structure, and (b) of FIG. 5B is a perspective view of the wideband antenna structure. A first conductive pattern 1111 having an inverted triangle structure may be disposed integrally with second and third conductive patterns 1112 and 1113 disposed to be apart from a side surface of the metal frame 1320.

Referring to FIG. 5B, the conductive pattern 1110 corresponding to a radiator may be placed on the metal frame 1320. The metal frame 1320 may be configured as a metal frame having a metal material, but some regions may not include metal. The conductive pattern 1110 may be connected to the metal frame 1320 at a feed point FP. The conductive pattern 1110 may be configured to be in contact with a point of the metal frame 1320. The metal frame 1320 may be configured such that the conductive pattern 1110 is connected to ground GND at one point. One side surface of the conductive pattern 1110 may be spaced apart from one side surface of the metal frame 1320 to define a slot region SR.

In relation to this, a feeding structure of an antenna may have both a feeding portion and a short-circuit portion both connected to an antenna pad on a printed circuit board (PCB). However, a structure proposed in the present disclosure is different from this feeding structure in that a feeding portion of an antenna is connected to a pad of a PCB, but a short-circuit portion connected to ground is connected to ground of the metal frame 1320 made of metal and having a mechanical structure. By connecting the ground to the mechanism structure, a slot mode may be defined between the conductive pattern 1110 and the ground of the mechanism structure. In addition, an effect of an increase in a bandwidth of the MB and the HB may also be achieved through a conductive pattern of a feeding structure having a triangular shape.

Meanwhile, the conductive pattern 1110 may be disposed on an inner cover 1310 as shown in FIG. 5C and FIGS. 7 to 8B to be described later. Referring to FIG. 5C, the conductive pattern 1110 disposed on the inner cover 1310 may be spaced apart from the metal frame 1320 made of a metal material to define a slot region. In addition, the conductive pattern 1110 disposed on the inner cover 1310 may be connected to the metal frame 1320 made of a metal material through a ground contact portion 1110g.

Referring to (a) of FIG. 5C, the inner cover 1310 may be configured to include a front surface 1311, one side surface 1312, another side surface 1313, and an inclined region 1314. The conductive pattern 1110 may be disposed on the front surface 1311, the inclined region 1314, and the one side surface 1312 each included in the inner cover 1310. (b) of FIG. 5C shows that the inner cover 1310 may be configured to include the front surface 1311, the one side surface 1312, the another side surface 1313, first and second inclined regions 1314a and 1314b, and a connecting portion 1315. The conductive pattern 1110 may be disposed on the front surface 1311, the first and second inclined regions 1314a and 1314b, the connecting portion 1315, and the one side surface 1312 each included in the inner cover 1310.

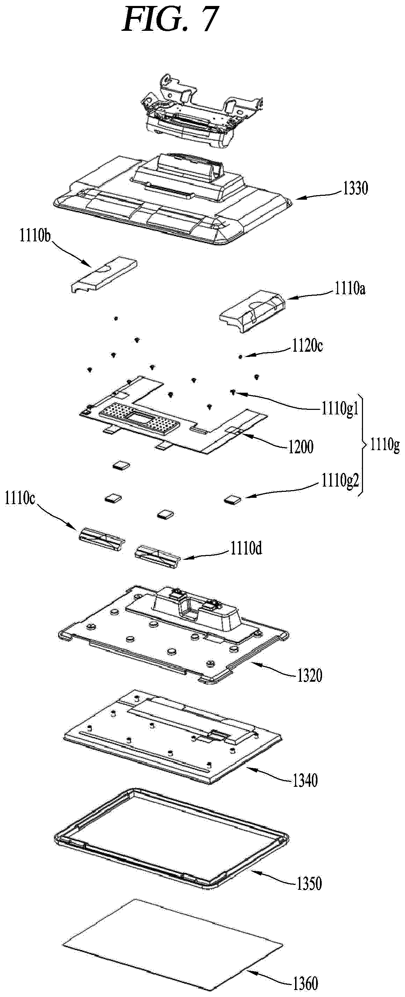

The conductive pattern 1110 of (b) of FIG. 5C may be disposed to have a shape corresponding to a shape of an outer cover 1330, i.e., a rear cover as shown in (c) of FIG. 5C. A second sub-pattern 1111b may be disposed in the first and second inclined regions 1314a and 1314b and the connecting portion 1315 each included in the inner cover 1310. The second sub-pattern 1111b may include first to third pattern regions PR1, PR2, and PR3. The first to third pattern regions PR1, PR2, and PR3 may be disposed in the first inclined region 1314a, the connecting portion 1315, and the second inclined region 1314b, respectively. Accordingly, the conductive pattern 1110 of (b) of FIG. 5C may minimize a change in antenna characteristics according to a shape of the outer cover 1330 of (c) of FIG. 5C. Meanwhile, a detailed structure of an antenna structure of FIG. 5C is to be described in detail together with a mechanical structure of FIGS. 7 to 8B.

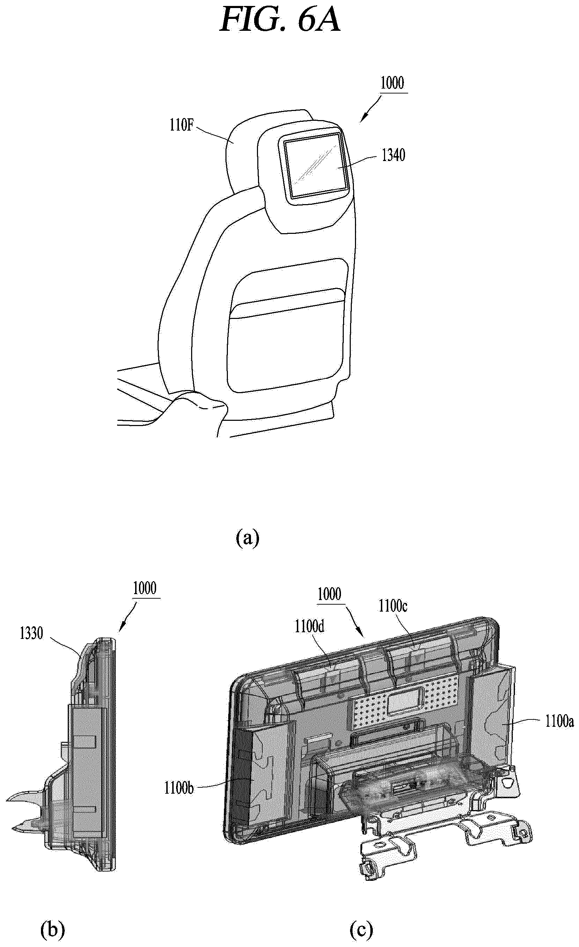

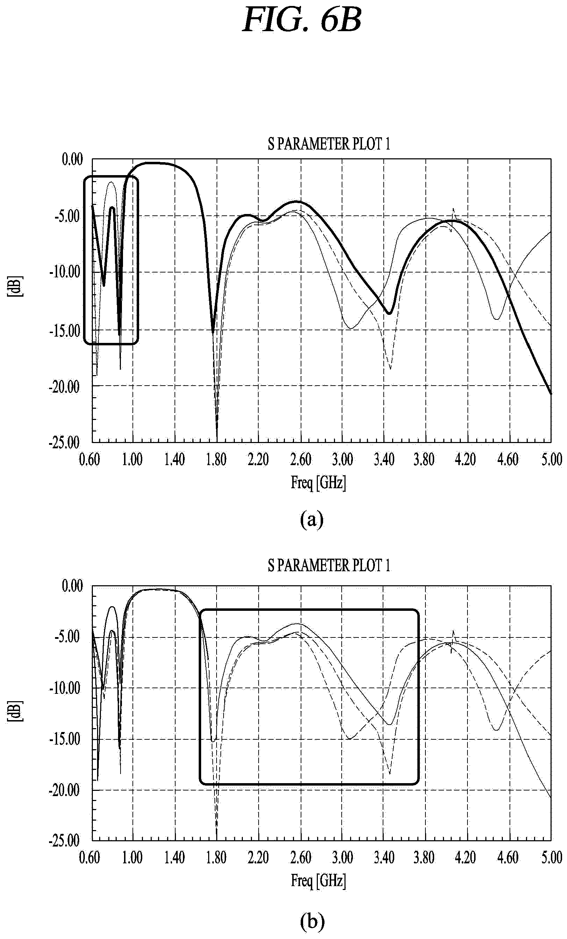

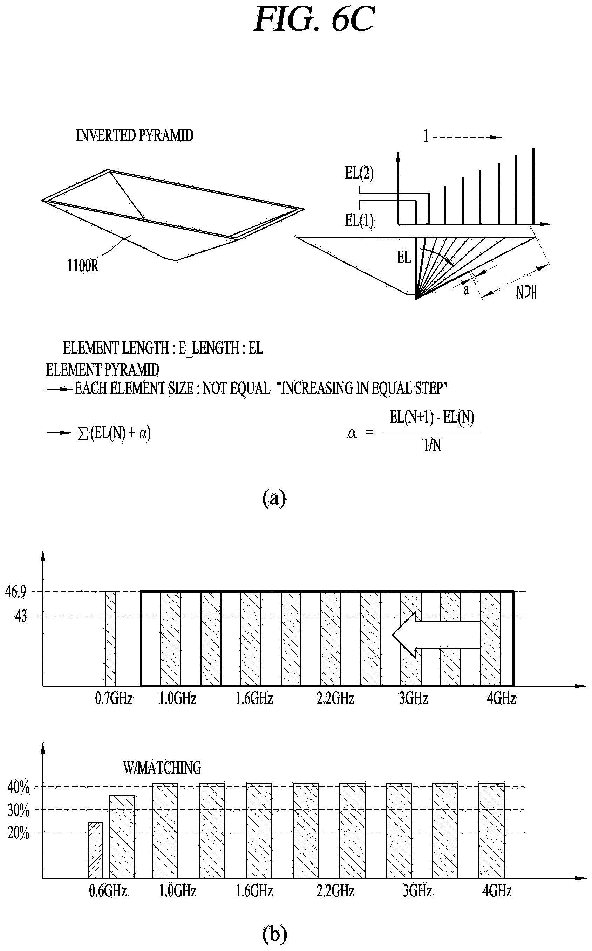

FIG. 6A illustrates a structure in which a wideband antenna module is placed in a rear seat of a vehicle. FIG. 6B illustrates antenna characteristics in the LB and HB when a matching circuit is disposed in a feeding portion of the antenna structure of FIG. 5C. Meanwhile, FIG. 6C is a conceptual diagram illustrating a principle in which wideband characteristics is implemented by a conductive pattern having a tapering shape included in the antenna structure of FIG. 5C.

Referring to FIG. 1B and (a) of FIG. 6A, an antenna assembly 1000 may be placed in a seat 110F, 110FL, or 110FR of a vehicle. The antenna assembly 1000 may be configured to include a display module 1340. At least one wideband antenna may be placed inside the antenna assembly 1000. The display module 1340 implemented in the antenna assembly 1000 may be placed on the seat 110F, i.e., a front seat of the vehicle.

While a user in a rear seat of the vehicle views content through the display module 1340, the vehicle may perform wireless communication through an antenna in the antenna assembly 1000. The antenna assembly 1000 may be configured to perform wireless communications within the vehicle and wireless communication between the vehicle and another vehicle or a wireless entity outside the vehicle. The seat 110F of the vehicle in which the antenna assembly 1000 is placed is a front seat, but constitutes a display for a user in a rear seat of the vehicle. Accordingly, a display in the seat 110F of the vehicle may be considered as being placed in the rear seat of the vehicle.

(b) of FIG. 6A and (c) of FIG. 6A illustrate a side view and a perspective view of the antenna assembly 1000 that may be placed in the rear seat of the vehicle, respectively. Referring to (b) of FIG. 6A and (c) of FIG. 6A, a PCB 1200 may be placed in the outer cover 1330 corresponding to a rear cover. A plurality of antennas may be placed in different regions of the PCB 1200. A first antenna 1100a and a second antenna 1100b may be disposed on one side region and another side region of the PCB 1200, respectively. A third antenna 1100c and a fourth antenna 1100d may be placed on an upper left side and an upper right side of the PCB 1200, respectively.

Referring to FIGS. 5B, 5C, and 6B, the wideband antenna structure according to the present disclosure is configured as an antenna that operates in a slot mode using the conductive pattern 1110 and an antenna pattern. Accordingly, the wideband antenna structure according to the present disclosure may be referred to as a pattern integrated slot antenna (PISA). The wideband antenna structure may be designed with reference to a reflection coefficient of -6 dB over an operating frequency bandwidth of approximately 617 MHz to 6 GHz. In relation to this, the wideband antenna structure may be designed with reference to a reflection coefficient of -6 dB in an operating frequency bandwidth of 617 MHz to 960 MHz in the LB and 1600 MHz to 5000 MHz in the MB and HB. A dual resonance mode may be implemented in the LB through a dual slot structure having the first and second slot regions GSR1 and GSR2.

A feeding portion may be disposed at the feed point FP at an end portion of a third sub-pattern 1111c of the first conductive pattern 1111. The feeding portion disposed at the feed point FP may be connected to an impedance matching portion 1120. The impedance matching portion 1120 may be configured to include a capacitor C and an inductor L connected to each other in series. A capacitance value of the capacitor C may be set to 3 pF, but is not limited thereto. An inductance value of the inductor L may be set to 2 nH, but is not limited thereto.

Referring to FIG. 5B and (a) of FIG. 6B, impedance matching characteristics may be improved in the LB through the capacitor C of 3 pF. In relation to this, in (a) of FIG. 6B, a dotted line represents reflection coefficient characteristics when an impedance matching portion is not disposed, and a solid line represents reflection coefficient characteristics when an impedance matching portion is disposed.

Referring to FIG. 5C and (b) of FIG. 6B, impedance matching characteristics may be improved in the MB and the HB through the inductor L of 2 nH. In relation to this, in (b) of FIG. 6B, a dotted line represents reflection coefficient characteristics when an impedance matching portion is not disposed, and a solid line represents reflection coefficient characteristics when an impedance matching portion is provided.

(a) of FIG. 6C shows an inverted-pyramidal radiator structure with a cross-section having an inverted triangle structure, with respect to the conductive pattern 1110 having a tapering shape of FIG. 5c. Referring to (a) of FIG. 6C, a cross-section of an inverted-pyramidal radiator 1100R may be equivalent to the conductive pattern 1110 having a tapering shape of FIG. 5C.

In relation to this, in the present disclosure, an antenna that covers a full band of 4G/5G wireless communication from about 600 MHz to 4 GHz or greater is needed. Referring to (b) of FIG. 6C, an antenna configured as the inverted-pyramidal radiator 1100R may operate as a radiator in the MB and the HB. Meanwhile, antenna efficiency of 40% or higher may be implemented in the LB by a slot structure between the first conductive pattern 1111 and the metal frame 1320 separately from the first conductive pattern 1111 of FIG. 5C corresponding to the inverted-pyramidal radiator 1100R.

Referring to FIGS. 5C and 6C, the inverted-pyramidal radiator 1100R may be modeled by metal elements having different element sizes. Thus, resonance modes may be generated in several bands corresponding to the different element sizes. Accordingly, the inverted-pyramidal radiator 1100R may perform broadband operation in the MB and the HB.

It may be understood that multiple resonant modes are generated in an antenna assembly having a structure of the inverted-pyramidal radiator 1100R to cover a full band from about 600 MHz to 4 GHz or higher. Therefore, an antenna module covering a full band from 600 MHz to 4 GHz or higher may be implemented using a technique such as impedance matching.

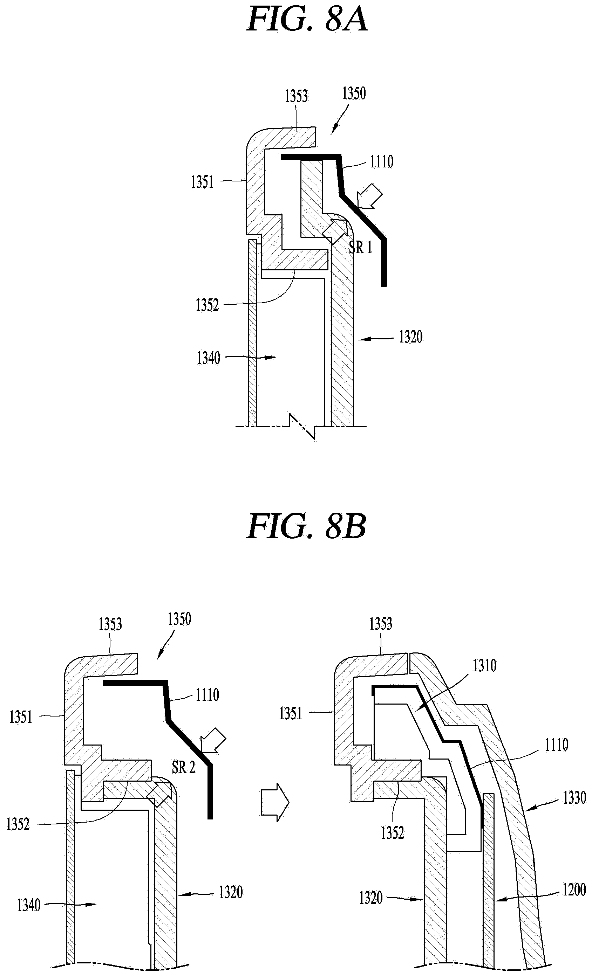

Meanwhile, FIG. 7 is an exploded view of an antenna assembly for a vehicle in which a plurality of antenna modules are disposed in a rear seat of the vehicle according to the present disclosure. Meanwhile, FIGS. 8A and 8B illustrate side views of an antenna assembly according to embodiments. FIG. 8A illustrates a structure in which the conductive pattern 1110 is coupled to the metal frame 1320) to have a slot region SR1 disposed between the conductive pattern 1110 and the metal frame 1320. FIG. 8B illustrates a structure in which the conductive pattern 1110 is coupled to a feeding portion of the PCB 1200 and a slot region SR2 is disposed between the conductive pattern 1110 and the metal frame 1320. Referring to FIG. 8B, a lower region of the PCB 1200 may be coupled to the conductive pattern 1110 to reduce a height of a whole antenna structure. Additionally, the conductive pattern 1110 may be coupled to a lower feeding structure at a lower end portion in a lower region of the PCB 1200 to prevent interference of a signal radiated through the conductive pattern 1110 by the metal frame 1320.

Referring to FIGS. 8A and 8B, a radiation structure for securing a distance between an antenna implemented with the conductive pattern 1110 and the metal frame 1320 may be adopted. To do so, the conductive pattern 1110 constituting the radiation structure may be coupled to the lower feeding structure at the lower end portion in the lower region of the PCB 1200. In addition, the conductive pattern 1110 may be coupled to the metal frame 1320 supporting a front cover 1350 and the display module 1340 to shield an electromagnetic wave emitted from the display module 1340. The metal frame 1320 and the front cover 1350 may constitute a shielding member.

Referring to FIGS. 5B to 8B, the antenna assembly 1000 mounted on a vehicle may be configured to include the inner cover 1310, the conductive pattern 1110, and the metal frame 1320. The antenna assembly 1000 may be configured to further include the outer cover 1330 and the slot regions SR1 and SR2.

The inner cover 1310 is made of a dielectric material and may include the front surface 1311, and the one side surface 1312 and the another side surface 1313 each extending from the front surface 1311.

The conductive pattern 1110 may be disposed to extend from the feed point FP on the front surface of the inner cover 1310 to the one side surface of the inner cover 1310. The conductive pattern 1110 may be configured to have a tapering shape from the one side surface to the feed point FP on the front surface to transmit or receive a wireless signal. The metal frame 1320 may be configured to be in contact with one point of the conductive pattern 1110. The metal frame 1320 may be configured such that the conductive pattern 1110 is connected to the ground GND at the one point.

The outer cover 1330 may be configured to be coupled to the inner cover 1310. In relation to this, the outer cover 1330 may be configured as a rear cover of the antenna assembly configured as a monitor module. The metal frame 1320 may be configured as a display frame configured to support the display module 1340. The slot regions SR1 and SR2 may be disposed between the conductive pattern 1110 and the metal frame 1330.

The conductive pattern 1110 may extend from both end portions of the one side surface 1312 to the front surface 1311 to define a first end point and a second end point. A first end point FP1 of the conductive pattern 1110 may be disposed to be curved toward the feed point. A second end point FP2 of the conductive pattern 1110 may be disposed to be curved toward the feed point. Accordingly, the conductive pattern 1110 may be configured to transmit or receive a wideband wireless signal. Therefore, the conductive pattern 1110 operates as a radiator, and thus, may also be referred to as a radiation pattern.

The conductive pattern 1110 may be configured to include a plurality of conductive patterns. The conductive pattern 1110 may be configured to include the first conductive pattern 1111 and the second conductive pattern 1112. As another example, the conductive pattern 1110 may be configured to include the first conductive pattern 1111, the second conductive pattern 1112, and the third conductive pattern 1113.

The first conductive pattern 1111 may be disposed to have a tapering shape from the one side surface of the inner cover 1310 toward the feed point FP on the front surface of the inner cover 1310. The second conductive pattern 1112 may extend from a first end portion of the one side surface of the inner cover 1310 to the front surface to define a first end point. The third conductive pattern 1113 may extend from a second end portion of the one side surface to the front surface of the inner cover 1310 to define a second end point. The first end point of the second conductive pattern 1112 may be disposed to be curved toward the feed point FP. The second end point of the third conductive pattern 1113 may be disposed to be curved toward the feed point FP.

A shape of the first conductive pattern 1111 may be configured as described below. In relation to this, the inner cover 1310 may further include the inclined region 1314 disposed to be inclined between the front surface 1311 and the one side surface 1312. **The** conductive pattern 1110 may be configured as a plurality of sub-patterns. **The** first conductive pattern 1111 may be configured to include a first sub-pattern 1111a and the second sub-pattern 1111b. **The** first sub-pattern 1111a may be disposed on the front surface 1311 of the inner cover 1310 to have a tapering shape, and have the feed point FP at an end portion. The second sub-pattern 1111b may be disposed in the inclined region 1314 of the inner cover 1310 to have a tapering shape. Accordingly, the first conductive pattern 1111 may be disposed to have a tapering shape from the inclined region 1314 of the inner cover 1310 toward the feed point of the front surface 1311 of the inner cover 1310.

As another example, the first conductive pattern 1111 may be configured to include the first sub-pattern 1111a, the second sub-pattern 1111b, and the third sub-pattern 1111c. The first sub-pattern 1111a is disposed on the front surface 1311 of the inner cover 1310 to have a tapering shape, and have the feed point FP at an end portion. The second sub-pattern 1111b may be disposed in the inclined region 1314 of the inner cover 1310 to have a tapering shape. The third sub-pattern 1111c may be disposed on the one side surface of the inner cover to have a first width W1 and a first length L1. A distance between points connecting from the second sub-pattern 1111b to the third sub-pattern 1111c may be configured as a second width W2 smaller than the first width W1. A distance between points connecting from the first sub-pattern 1111a to the second sub-pattern 1111b may be configured as a third width W3 smaller than the second width W2 Accordingly, the first conductive pattern 1111 may be disposed to have a tapering shape from the one side surface 1312 of the inner cover 1310 toward a feed point of the front surface 1311 of the inner cover 1310.

Meanwhile, at least one of the second conductive pattern 1112 and the third conductive pattern 1113 may be configured to be connected to the third sub-pattern 1111c disposed on the one side surface 1312 of the inner cover 1310, among the first conductive pattern 1111. In detail, the second conductive pattern 1112 may be connected to the third sub-pattern 1111c in the inclined region 1314 of the inner cover 1310. Accordingly, the first end point FP1 of the second conductive pattern 1112 may be disposed to be inwardly curved toward the feed point FP. The third conductive pattern 1113 may be connected to the third sub-pattern 1111c in the inclined region 1314 of the inner cover 1310. Accordingly, the second end point FP2 of the third conductive pattern 1113 may be disposed to be inwardly curved toward the feed point FP.

Meanwhile, at least one of the second conductive pattern 1112 and the third conductive pattern 1113 may be configured to be spaced apart from the second sub-pattern 1111b disposed on the inclined region 1314 of the inner cover 1310, among the first conductive pattern 1111. In detail, the second conductive pattern 1112 may be configured to have a fourth width W4 at a first end portion of the first conductive pattern 1111 and be spaced apart from the second sub-pattern 1111b by a first gap G1. The third conductive pattern 1113 may be configured to have a fifth width W5 at a second end portion of the first conductive pattern 1111 and be spaced apart from the second sub-pattern 1111b by a second gap G2. In relation to this, a sum of the second width W2, the fourth width W4, the fifth width W5, the first gap G1, and the second gap G2 may be configured to be equal to the first width W1 of the third sub-pattern 1111c disposed on the one side surface of the inner cover 1310.

The antenna 1100 according to by the conductive pattern 1110 may be configured to operate in the LB, the MB, the HB, and an ultra-high band (UHB) for 4G wireless communication and 5G wireless communication. The antenna 1100 may be configured to include the conductive pattern 1110 and the inner cover 1310. The antenna 1100 may be configured to include the slot region SR between the conductive pattern 1110 and the metal frame 1320. A plurality of antennas 1100 may be arranged within the outer cover 1330 configured as a rear cover constituting the antenna assembly 1000. The antennas 1100 may further include the first antenna 1100a and the second antenna 1100b arranged on one side in the outer cover 1330.

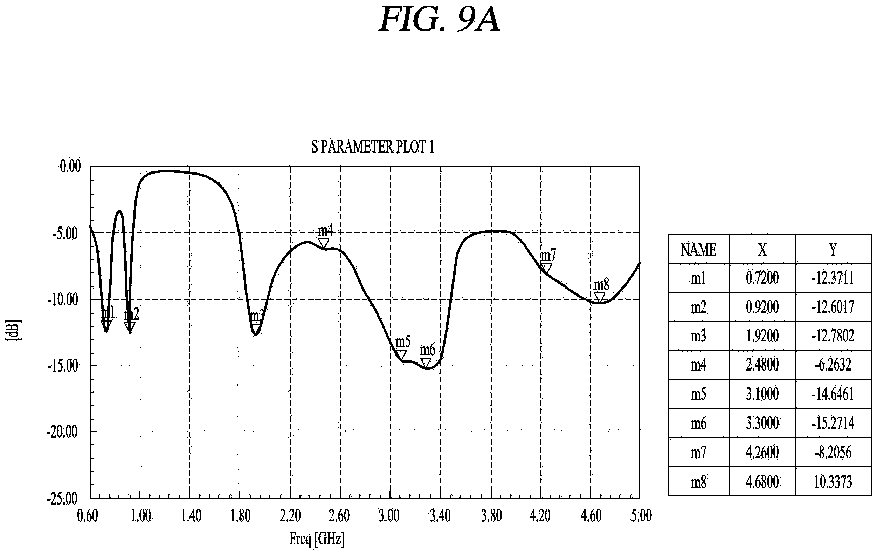

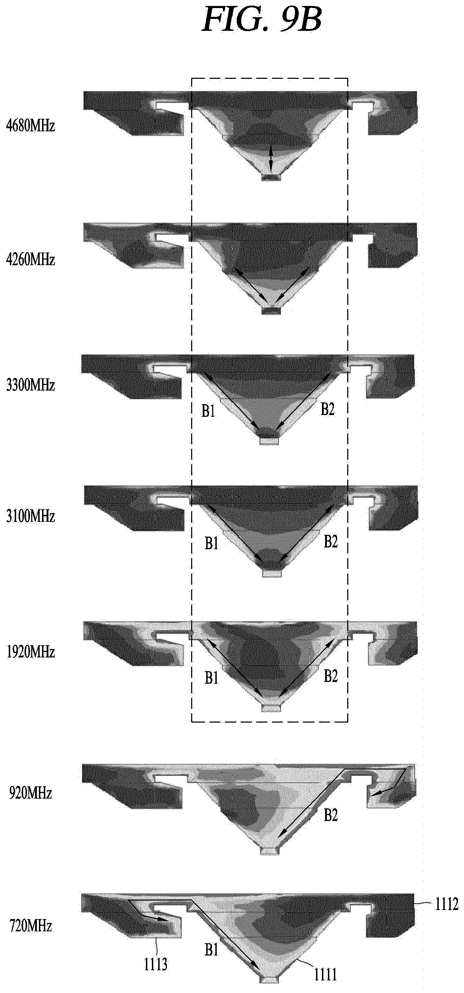

As a current is supplied through different regions of the conductive pattern 1110 for each frequency band, the antenna 1100 may operate as a radiator in a wide band. In relation to this, FIG. 9A shows reflection coefficient characteristics for the radiator structure of FIG. 5B. FIG. 9B shows a current distribution in each frequency band for the radiator structure of FIG. 5B.

Referring to FIG. 5B, a PISA structure may operate as a slot mode in the LB from a contact point between the conductive pattern 1110 that is an antenna pattern, and the metal frame 1320 that is a mechanical structure. The slot mode may be defined through a slot structure between the conductive pattern 1110 and the metal frame 1320 in the LB. In this regard, as shown in FIG. 9B, a current pattern may be configured in parallel to a slot structure and one of both side boundaries of the conductive pattern 1110 in the LB to define a slot mode. The current pattern may be defined along both the side boundaries of the conductive pattern 1110 in the MB and the HB. Wideband operation may be performed in the MB and the HB through the conductive pattern 1110 in a tapering form to have a monotonically increasing area and the slot mode of the slot structure. Therefore, a wideband antenna structure in the LB operates in the slot mode. The wideband antenna structure operates in a mode in which a radiator mode and the slot mode are combined with each other in the MB and in the HB.

Referring to FIG. 9A, the antenna 1100 may be configured to dual resonate at a first frequency and a second frequency in the LB. The first frequency and the second frequency may be 720 MHz and 920 MHz, respectively, but are not limited thereto. The antenna 1100 may be configured to resonate in the MB and the HB. In relation to this, a third frequency and a fourth frequency in the MB may be 1920 MHz and 2480 MHz, respectively, but are not limited thereto. A fifth frequency and a sixth frequency in the HB may be 3100 MHz and 3300 MHz, respectively, but are not limited thereto. In addition, the antenna 1100 may be configured to resonate in the UHB. In relation to this, a seventh frequency and an eighth frequency may be 4260 MHz and 4680 MHz, respectively, but are not limited thereto.

Referring to FIGS. 5B and 9B, the antenna 1100 may be configured to radiate a wireless signal at the first frequency in the LB as a current is supplied through the first conductive pattern 1111 and the third conductive pattern 1113. The first frequency in the LB may be 720 MHz, but is not limited thereto. The antenna 1100 may be configured to radiate a wireless signal at the second frequency in the LB as a current is supplied through the first conductive pattern 1111 and the second conductive pattern 1112. The second frequency in the LB may be 920 MHz, but is not limited thereto. In relation to this, the third conductive pattern 1113 may be configured to have an area larger than that of the second conductive pattern 1112. At the first frequency in the LB, the antenna 1100 may be configured such that a current is supplied through the third conductive pattern 1113 having an area larger than that of the first conductive pattern 1111 and the second conductive pattern 1112. At the second frequency in the LB, the antenna 1100 may be configured so that a current is supplied through the second conductive pattern 1112 having an area smaller than that of the first conductive pattern 1111 and the third conductive pattern 1112.

The antenna 1100 may be configured to radiate a wireless signal in the MB and the HB as a current is supplied through boundary regions on both sides of the tapering shape of the first conductive pattern 1111. In relation to this, the antenna 1100 may be configured such that current is supplied through the boundary regions on both sides of the tapering shape at 3100 MHz and 3300 MHz corresponding to the MB and the HB, respectively.

The antenna 1100 may be configured to radiate a wireless signal in the UHB as a current is supplied through an inner region of the tapering shape of the first conductive pattern 1111. In relation to this, the antenna 1100 may be configured such that current is supplied through the inner region of the tapering shape at 4260 MHz and 3300 MHz corresponding to the UHB. The inner region of the tapering region in the first conductive pattern 1111 may be defined as a central region compared to the boundary regions on both sides. The inner region of the tapering shape of the first conductive pattern 1111 may have a shorter length of resonance caused by current compared to the boundary regions on both sides to operate as a radiator in a higher frequency band.

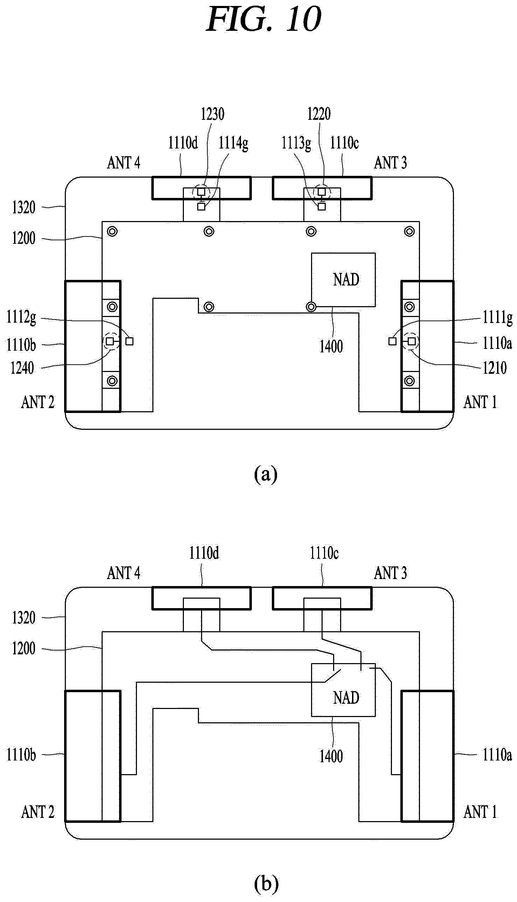

Meanwhile, hereinafter, a detailed configuration of an antenna assembly constituting a rear seat monitor of a vehicle according to the present disclosure is described in detail. Referring to FIG. 7, the antenna assembly 1000 may be configured to include the PCB 1200. In relation to this, FIG. 10 illustrates a structure in which a plurality of antennas arranged in different regions of a PCB included in an antenna assembly according to the present disclosure are connected to a network access device (NAD). (a) of FIG. 10 illustrates a plurality of antenna structures capable of being coupled to different regions of the PCB 1200. (b) of FIG. 10 illustrates an interface structure in which each of the first to fourth antennas 1110a to 1110d is coupled to an NAD 1400 via a radio frequency (RF) cable.

Referring to FIG. 10, the second antenna 1100b arranged on one side surface of the metal frame 1320 supporting a display module may be implemented to have a length connected to the NAD 1400 to be equal to or greater than a predetermined length. As an example, a length between the second antenna 1100b and the NAD 1400 may be implemented to be approximately 250 mm, and accordingly, an RF path loss equal to or greater than a certain level may occur in a band of 3 GHz to 5 GHz. To minimize this RF path loss, the second antenna 1100b may be connected to the NAD 1400 using a separate RF cable on the PCB 1200 instead of a microstrip line type. A coaxial cable may be configured as an example of an RF cable. An RF interface between each of the first to fourth antennas 1110a to 1110d and the NAD 1400 may be implemented using the RF cable, i.e., a coaxial cable.

Meanwhile, different points of the PCB 1200 and the metal frame 1320 may be connected through first to fourth ground contact portions 1111g to 1114g. The first to fourth antennas 1110a to 1110d may be connected to the metal frame 1320 through the first to fourth ground contact portions 1111g to 1114g, respectively, to provide a stabilized ground structure. Accordingly, the antenna assembly according to the present disclosure adopts an antenna structure and an internal cover structure for reducing an overall height and an RF cable fastening structure for compensating for an RF path loss. In addition, the first to fourth antennas 1110a to 1110d are connected to the metal frame 1320 through the first to fourth ground contact portions 1111g to 1114g, respectively, to apply a stabilized ground structure to secure stable antenna characteristics. The first to fourth ground contact portions 1111g to 1114g may be implemented as metal screws, but are not limited thereto.

Referring to FIGS. 7, 8A, and 10, the PCB 1200 may be configured to be connected, at the feed point FP, to the conductive pattern 1110 disposed on a front surface of the inner cover 1310. The PCB 1200 may be arranged between the display panel 1320 and the outer cover 1330. The antenna assembly 1000 may be configured to further include the ground contact portion 1110g.

The ground contact portion 1110g may be disposed between the PCB 1200 and the metal frame 1320 so that the conductive pattern 1110 disposed on one side surface of the inner cover 1310 comes into contact with the metal frame 1320. The ground contact portion 1110g may include first and second ground contact portions 1110g1 and 1110g2. The first ground contact portion 1110g1 may be configured to connect ground of the PCB 1200 to the conductive pattern 1110. The second ground contact portion 1110g2 may be configured to connect the ground of the PCB 1200 to the metal frame 1320. The antenna contact portion 1120c may be configured to connect the conductive pattern 1110 to a signal pattern of the PCB 1200.

Meanwhile, a step may occur due to a height difference between the conductive pattern 1110 disposed on the inner cover 1310 and the metal frame 1320. Accordingly, the ground contact portion 1110g may be configured as a finger type structure having a horizontal pattern portion and a vertical pattern portion to compensate for the step between the conductive pattern 1110 disposed on the inner cover 1310 and the metal frame 1320.

The PCB 1200 may have a feed pattern 1210 disposed to be connected to the feed point FP of the conductive pattern 1110. The feed pattern 1210 may be configured to include a first feed pattern 1210a to a fourth feed pattern 1210d to apply a signal to the first antenna 1100a to the fourth antenna 1100d.

The antenna assembly 1000 may be configured to further include the display module 1340. The display module 1340 may be fixed to the metal frame 1320 and configured to display screen information. The metal frame 1320 may be implemented as a display frame configured to support the display module 1340. The display module 1340 may be implemented as an LCD module, but is not limited thereto.

The antenna assembly 1000 may be configured to further include the front cover 1350. The front cover 1350 may include a front surface 1351, an inner side surface 1352, and an outer side surface 1353, and be configured to support the display module 1340 through the inner side surface 1352. The front cover 1350 may be disposed so that the metal frame 1320 and the conductive pattern 1110 are arranged in a space between the inner side surface 1352 and the outer side surface 1353. Glass 1360 may be placed on a front surface of the display module 1340, and the glass 1360 may be combined with the front cover 1350.

The slot regions SR1 and SR2 between the conductive pattern 1110 and the metal frame 1320 may be disposed on the inner side surface 1352 of the front cover 1350. The first slot region SR1 may be disposed between the conductive pattern 1110 and the metal frame 1320, and spaced apart from the conductive pattern 1110 by a first gap SG1. The second slot region SR2 is disposed between the conductive pattern 1110 and the metal frame 1320 coupled to the front cover 1350, and may be spaced apart from the conductive pattern 1110 by a second gap SG2. Since the second gap SG2 of the second slot region SR2 is configured to be greater than the first gap SG1 of the first slot region SR1, antenna performance such as bandwidth characteristics may be improved. In this regard, even though the second gap SG2 of the second slot region SR2 increases, a size of a whole structure constituting the antenna assembly does not further increase.

Meanwhile, the antenna assembly 1000 according to the present disclosure may be placed inside a rear seat monitor module placed in a rear seat of a vehicle as illustrated in FIG. 6A. Accordingly, the antenna assembly 1000 may be configured to perform wireless communications within the vehicle and wireless communication between the vehicle and another vehicle or a wireless entity outside the vehicle.

Meanwhile, the antenna assembly 1000 according to the present disclosure may be configured so that a plurality of antennas are arranged. In this regard, as illustrated in FIGS. 7 and 10, the antenna assembly 1000 may include the first antenna 1100a and the second antenna 1100b arranged on left and right sides of the rear seat monitor module, respectively. Accordingly, MIMO operation may be performed through the antenna assembly 1000 constituting the rear seat monitor module placed in the rear seat of the vehicle. 2X2 MIMO operation may be performed through the first antenna 1100a and the second antenna 1100b.

The antenna assembly 1000 may further include the third antenna 1100c and the fourth antenna 1100d positioned on upper left and upper right sides of the rear seat monitor module, respectively. The first antenna 1100a may be placed in a further left region compared to the third antenna 1100c. The second antenna 1100b may be placed in a further right region compared to the fourth antenna 1100d.

In relation to this, the third antenna 1100c and the fourth antenna 1100d may be placed on a lower left side and on a lower right side of the rear seat monitor module, respectively. As another example, the third antenna 1100c and the fourth antenna 1100d may be placed on an upper side and a lower side of the rear seat monitor module, respectively. Up to 4X4 MIMO operation may be performed through the first antenna 1100a to the fourth antenna 1100d.

Meanwhile, the antenna assembly 1000 according to the present disclosure may be configured to further include the NAD 1400. The NAD 1400 may be arranged in the PCB 1200. The NAD 1400 may be coupled to the first antenna 1100a to the fourth antenna 1100d to control to perform MIMO operation through the first antenna 1100a to the fourth antenna 1100d. The NAD 1400 may be connected to the first antenna 1100a to the fourth antenna 1100d via a coaxial cable to reduce an RF signal loss.

The antenna assembly for a vehicle according to one aspect of the present disclosure has been described. Hereinafter, an antenna assembly for a vehicle according to another aspect of the present disclosure is to be described.

Referring to FIGS. 5B to 8B, an antenna assembly 1000b mounted on a vehicle may be configured to include the display module 1340, the inner cover 1310, the conductive pattern 1110, the front cover 1350, and the outer cover 1330. In this regard, the antenna assembly 1000b may be configured such that the metal frame 1320 is coupled to the front cover 1350 as shown in FIG. 8B.

The slot region SR2 disposed between the conductive pattern 1110 and the metal frame 1320 may be disposed on the inner side surface 1352 of the front cover 1350. The second slot region SR2 may be disposed between the conductive pattern 1110 and the metal frame 1320 coupled to the front cover 1350, and spaced apart from the conductive pattern 1110 by the second gap SG2. Since the second gap SG2 of the second slot region SR2 is configured to be larger than the first gap SG1 of the slot region SR1 of FIG. 8A, antenna performance such as bandwidth characteristics may be improved In this regard, even though the second gap SG2 of the second slot region SR2 increases, a size of a whole structure constituting the antenna assembly does not further increase.

The inner cover 1310 is made of a dielectric material and may include the front surface 1311, and the one side surface 1312 and the another side surface 1313 each extending from the front surface 1311.

The conductive pattern 1110 may be disposed to extend from the feed point FP on the front surface of the inner cover 1310 to the one side surface of the inner cover 1310. The conductive pattern 1110 may be configured to have a tapering shape from the one side surface to the feed point FP on the front surface to transmit or receive wireless signals.

The metal frame 1320 may be configured to surround a rear surface and side surfaces of the display module. The metal frame 1320 may be configured as a display frame configured to support the display module 1340. The front cover 1350 may include the front surface 1351, the inner side surface 1352, and the outer side surface 1353, and be configured to support the display module 1340 through the inner side surface 1352. The front cover 1350 may be disposed so that the metal frame 1320 and the conductive pattern 1110 are arranged in a space between the inner side surface 1352 and the outer side surface 1353. The slot region SR2 may be disposed between the conductive pattern 1110 and the metal frame 1330.

The conductive pattern 1110 may extend from both end portions of the one side surface 1312 of the inner cover 1310 to the front surface 1311 to define a first end point and a second end point. The first end point FP1 of the conductive pattern 1110 may be disposed to be curved toward a feed point. The second point FP2 of the conductive pattern 1110 may be disposed to be curved toward a feed point. Accordingly, the conductive pattern 1110 may be configured to transmit or receive a wideband wireless signal. Therefore, the conductive pattern 1110 operates as a radiator, and thus, may also be referred to as a radiation pattern.

The conductive pattern 1110 may be configured to include a plurality of conductive patterns. The conductive pattern 1110 may be configured to include the first conductive pattern 1111 and the second conductive pattern 1112. As another example, the conductive pattern 1110 may be configured to include the first conductive pattern 1111, the second conductive pattern 1112, and the third conductive pattern 1113.

The conductive pattern 1110 may include the first conductive pattern 1111 configured to have a tapering shape from the one side surface of the inner cover 1310 toward the feed point FP on the front surface of the inner cover 1310. The conductive pattern 1110 may include the second conductive pattern 1112 extending from a first end portion of the one side surface of the inner cover 1310 to the front surface to define a first end point. The conductive pattern 1110 may include the third conductive pattern 1113 extending from a second end portion of the one side surface of the inner cover 1310 to the front surface to define a second end point. The first end point of the second conductive pattern 1112 may be disposed to be curved toward the feed point FP. The second end point of the third conductive pattern 1113 may be disposed to be curved toward the feed point FP.

Hereinafter, a configuration of a shape of the first conductive pattern 1111 is described. In relation to this, the inner cover 1310 may further include the inclined region 1314 disposed to be inclined between the front side surface 1311 and the one side surface 1312. The conductive pattern 1110 may be configured to include a plurality of sub-patterns. The first conductive pattern 1111 may be configured to include the first sub-pattern 1111a and the second sub-pattern 1111b. As another example, the first conductive pattern 1111 may be configured to include the first sub-pattern 1111a, the second sub-pattern 1111b, and the third sub-pattern 1111c.

The conductive pattern 1110 may be disposed on the front surface 1311 of the inner cover 1310 to have a tapering shape, and include the first sub-pattern 1111a having the feed point FP disposed at an end portion. The conductive pattern 1110 may include the second sub-pattern 1111b configured to have a tapering shape in the inclined region 1314 of the inner cover 1310. Accordingly, the first conductive pattern 1111 may be disposed to have a tapering shape from the inclined region 1314 of the inner cover 1310 toward a feed point of the front surface 1311 of the inner cover 1310.

The conductive pattern 1110 may further include the third conductive pattern 1111c disposed on one side surface of the inner cover 1310 to have a first width D1 and a first length L1. A distance between points connecting from the second sub-pattern 1111b to the third sub-pattern 1111c may be configured as a second width W2 smaller than the first width W1. A distance between points connecting from the first sub-pattern 1111a to the second sub-pattern 1111b may be configured as a third width W3 smaller than the second width W2. Accordingly, the first conductive pattern 1111 may be disposed to have a tapering shape from the one side surface 1312 of the inner cover 1310 toward a feed point of the front surface 1311 of the inner cover 1310.

Meanwhile, at least one of the second conductive pattern 1112 and the third conductive pattern 1113 may be configured to be connected to the third sub-pattern 1111c disposed on the one side surface 1312 of the inner cover 1310, among the first conductive pattern 1111. In detail, the second conductive pattern 1112 may be connected to the third sub-pattern 1111c in the inclined region 1314 of the inner cover 1310. Accordingly, the first end point FP1 of the second conductive pattern 1112 may be disposed to be inwardly curved toward the feed point FP. The third conductive pattern 1113 may be connected to the third sub-pattern 1111c in the inclined region 1314 of the inner cover 1310. Accordingly, the second end point FP2 of the third conductive pattern 1113 may be disposed to be inwardly curved toward the feed point FP.

Meanwhile, hereinafter, a detailed configuration of an antenna assembly constituting a rear seat monitor of a vehicle according to the present disclosure is described in detail. Referring to FIGS. 7, 8B, and 10, the antenna assembly 1000b may be configured to include the PCB 1200.

The PCB 1200 may be configured to be connected, at the feed point FP, to the conductive pattern 1110 disposed on a front surface of the inner cover 1310. The PCB 1200 may be arranged between the metal frame 1320 and the outer cover 1330. The PCB 1200 may have the feed pattern 1210 disposed to be connected to the feed point FP of the conductive pattern 1110. The feed pattern 1210 may be configured to include the first feed pattern 1210a to the fourth feed pattern 1210d to apply a signal to the first antenna 1100a to the fourth antenna 1100d.

Meanwhile, the antenna assembly 1000b according to the present disclosure may be placed inside a rear seat monitor module placed in a rear seat of a vehicle as illustrated in FIG. 6A. Accordingly, the antenna assembly 1000b may be configured to perform wireless communications within the vehicle and wireless communication between the vehicle and another vehicle or a wireless entity outside the vehicle.

Meanwhile, the antenna assembly 1000 according to the present disclosure may be configured to have a plurality of antennas arranged therein. In this regard, as illustrated in FIGS. 7, 8B, and 10, the antenna assembly 1000 may include the first antenna 1100a and the second antenna 1100b arranged on left and right sides of a rear seat monitor module, respectively. Accordingly, MIMO operation may be performed through the antenna assembly 1000 constituting the rear seat monitor module placed in a rear seat of a vehicle. 2X2 MIMO operation may be performed through the first antenna 1100a and the second antenna 1100b.

The antenna assembly 1000 may further include the third antenna 1100c and the fourth antenna 1100d positioned on upper left and upper right sides of the rear seat monitor module. The first antenna 1100a may be placed in a further left region compared to the third antenna 1100c. The second antenna 1100b may be placed in a further right region compared to the fourth antenna 1100d.

In relation to this, the third antenna 1100c and the fourth antenna 1100d may be placed on a lower left side and on a lower right side of the rear seat monitor module, respectively. As another example, the third antenna 1100c and the fourth antenna 1100d may be placed on an upper side and a lower side of the rear seat monitor module, respectively. Up to 4X4 MIMO operation may be performed through the first antenna 1100a to the fourth antenna 1100d.

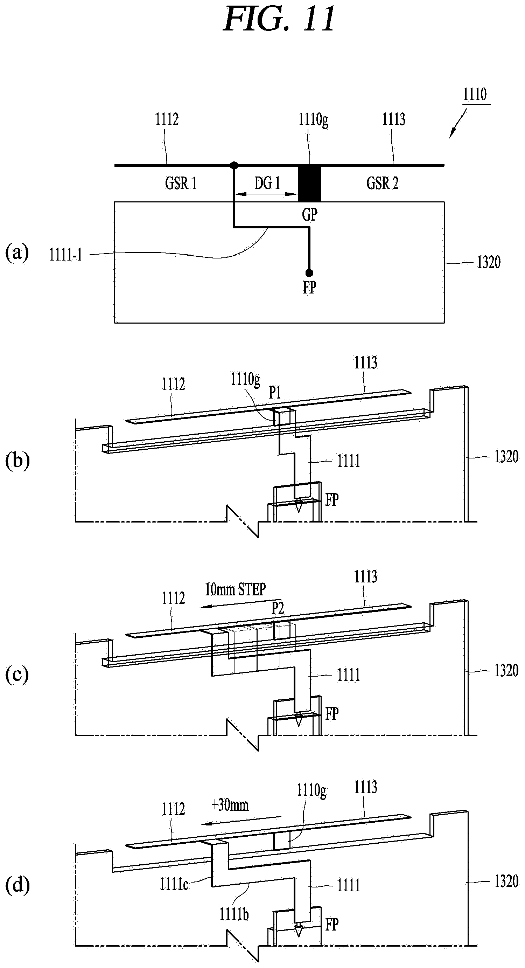

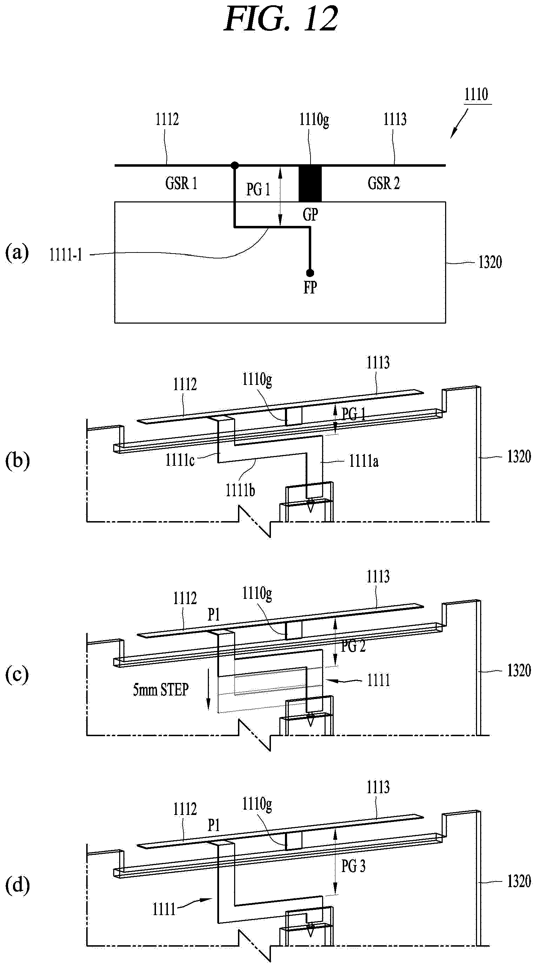

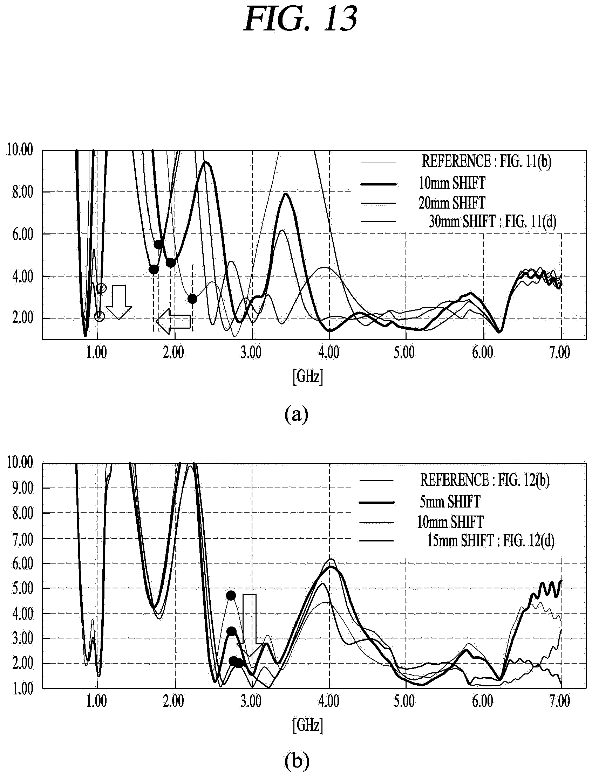

Meanwhile, the radiator structure of FIG. 5A according to the present disclosure may be a structure disposed on a front surface and one side surface of a frame (or an inner cover) and configured as illustrated in FIGS. 5B, 5C, and FIGS. 7 to 8B. Such a radiator structure may be referred to as PISA. In relation to this, FIG. 11 illustrates various structures in which a location where a feed pattern is connected to a conductive pattern is changed. FIG. 12 illustrates various structures in which a gap between the conductive pattern and the feed pattern is changed. FIG. 13 shows a VSWR result according to a change in radiator structures of FIGS. 11 and 12.

Referring to FIG. 11, the conductive pattern 1110 may be connected to the metal frame 1320 to be connected to ground. The conductive pattern 1110 may include the first conductive pattern 1111 arranged on a front surface of the metal frame 1320 and the second and third conductive patterns 1112 and 1113 arranged on a side surface of the metal frame 1320. The first conductive pattern 1111 may be connected to at least one of the second and third conductive patterns 1112 and 1113 arranged on a side surface of the metal frame 1320. The first conductive pattern 1111 applies a signal to the second and third conductive patterns 1112 and 1113, and thus, may be referred to as a feed pattern. The feed pattern such as the first conductive pattern 1111 constitutes a delay line, and thus, may be referred to as a delay feeding unit. A length of the conductive pattern 1110 may be set in units of a particular wavelength at a lowest frequency in an operating band. As an example, a length of the conductive pattern 1110 may be implemented as a length within a predetermined range based on a 1/4 wavelength with reference to 600 MHz.

Referring to (a) of FIG. 11, a first delay line 1111 corresponding to the first conductive pattern may be connected to the second conductive pattern 1112. Referring to FIG. (b) of FIG. 11, a position P1 connected to the first conductive pattern 1111 may correspond to a reference position spaced apart by a predetermined gap from a position in which the ground contact portion 1110g is disposed. Referring to (c) of FIG. 11, a position P2 connected to the first conductive pattern 1111 may be a position obtained by moving by a gap of 10 mm from the position in which the ground contact portion 1110g is disposed toward one side. Referring to (d) of FIG. 11, a position P3 connected to the first conductive pattern 1111 may be a position obtained by moving by 30 mm from a position in which the ground contact portion 1110g is disposed toward one side.

Referring to (a) of FIG. 13, as a position connected to the first conductive pattern 1111 is offset by a gap of 10 mm from a reference position, VSWR characteristics may be improved at a particular frequency in the LB. Additionally, as the position connected to the first conductive pattern 1111 is offset by a gap of 10 mm from the reference position, a lowest frequency among resonant frequencies in the MB and the HB shifts to a lower frequency. In summary, double resonance is generated in the LB at a point with an offset gap of approximately 20 mm. In addition, as a lowest frequency among resonant frequencies in the MB and HB shifts to a further lower frequency at an offset gap of approximately 20 mm, operating bands in the MB and the HB are broadened.

Referring to FIG. 12, the conductive pattern 1110 may be connected to the metal frame 1320 to be connected to ground. Referring to FIGS. 5A, 11, and 12, a length of the conductive pattern 1110 may be set to a length within a predetermined range based on a 1/4 wavelength with reference to a lowest frequency. Meanwhile, a length from the feed point FP of the first conductive pattern 1111 to a ground point GP of the ground contact portion 1110g may be set as a length within a predetermined range based on a 1/4 wavelength with reference to the lowest frequency. In relation to this, the lowest frequency may be set to 600 MHz which is a lowest frequency in the LB among antenna operating bands, but is not limited thereto.

The conductive pattern 1110 may include the first conductive pattern 1111 placed on a front surface of the metal frame 1320 and the second and third conductive patterns 1112 and 1113 placed on a side surface of the metal frame 1320. The first conductive pattern 1111 may be connected to at least one of the second and third conductive patterns 1112 and 1113 placed on the side surface of the metal frame 1320. The first conductive pattern 1111 applies a signal to the second and third conductive patterns 1112 and 1113, and thus, may be referred to as a feed pattern. The feed pattern such as the first conductive pattern 1111 constitutes a delay line, and thus, may be referred to as a delay feeding unit. The first conductive pattern 1110 may be configured to include the first sub-pattern 1111a to the third sub-pattern 1111c.

Referring to (a) of FIG. 12, antenna performance may be changed depending on a gap PG1 between the second and third conductive patterns 1112 and 1113 and the second sub-pattern 1111b. Referring to (b) of FIG. 12, the second sub-pattern 1111b may be placed at a reference position. Meanwhile, the second sub-pattern 1111b of (b) of FIG. 12 may be disposed to be offset with a gap of 5 mm with reference to the reference position as shown in (b) of FIG. 12. In relation to this, the reference position of (b) of FIG. 12 may be set such that the gap PG1 between the second and third conductive patterns 1112 and 1113 and the second sub-pattern 1111b is about 11.5 mm, but is not limited thereto. Referring to (c) of FIG. 12, a gap PG2 between the second and third conductive patterns 1112 and 1113 and the second sub-pattern 1111b may be increased by 5 mm compared to the gap PG1 shown in (a) of FIG. 12. Compared to the gap PG1 shown in (b) of FIG. 12, a gap PG3 between the second and third conductive patterns 1112 and 1113 and the second sub-pattern 1111b each shown in (d) of FIG. 12 is increased by 15 mm.

Referring to FIG. 12 and (b) of FIG. 13, as the gaps PG1, PG2, and PG3 between the second and third conductive patterns 1112 and 1113 and the second sub-pattern 1111b are increased, VSWR characteristics are improved in the MB. As the gaps PG1, PG2, and PG3 between the second and third conductive patterns 1112 and 1113 and the second sub-pattern 1111b increase from the reference position by 5 mm, respectively, up to 15 mm, impedance characteristics are improved. As the gaps PG2 and PG3 increase from 5 mm to 15 mm with respect to the reference position of (a) of FIG. 12, impedance characteristics are improved in a frequency band of 2.5 GHz or higher.

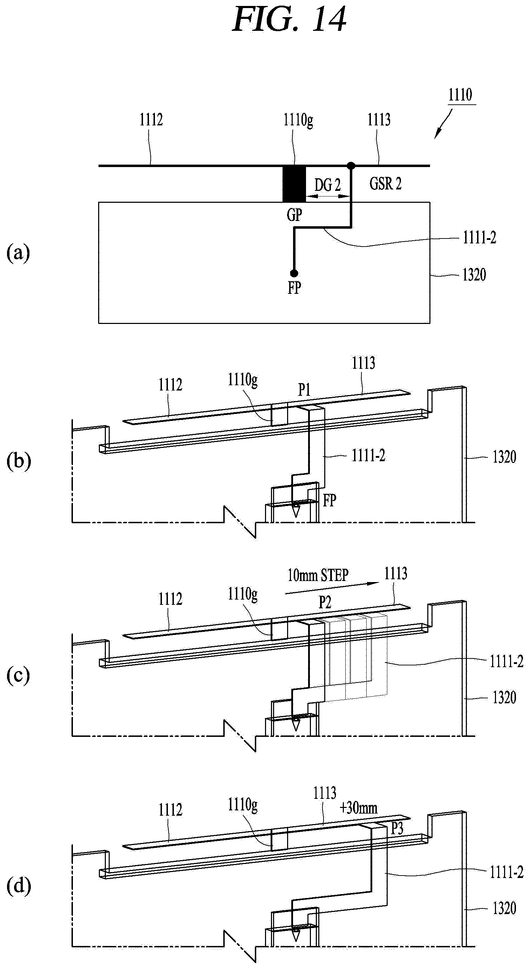

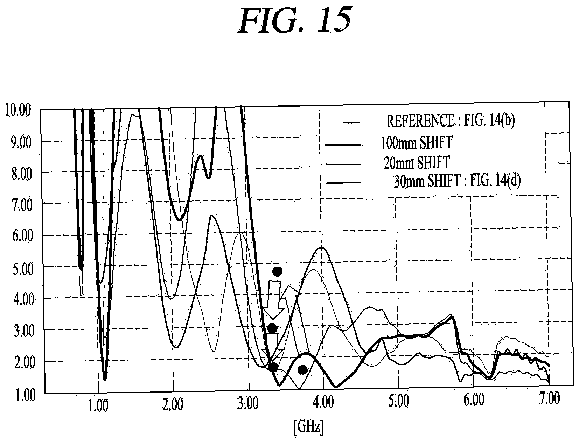

FIG. 14 shows radiator structures in which a delay line is placed on another side of the conductive pattern. FIG. 15 shows a VSWR result according to radiator structures of FIG. 14. In relation to this, FIGS. 11 and 12 illustrate a radiator structure in which a delay line is arranged on one side of a conductive pattern. The delay line of FIGS. 11 and 12 may be referred to as a first delay line, and the delay line of FIG. 14 may be referred to as a second delay line. The delay line of FIGS. 11 and 12 may be referred to as the first conductive pattern 1111. The delay line of FIG. 14 may be referred to as the second conductive pattern 1111-2.

Referring to FIG. 14, the conductive pattern 1110 may be connected to the metal frame 1320 to be connected to ground. The conductive pattern 1110 may include the second conductive pattern 1111-2 placed on a front surface of the metal frame 1320 and the second and third conductive patterns 1112 and 1113 placed on a side surface of the metal frame 1320. The second conductive pattern 1111-2 may be connected to at least one of the second and third conductive patterns 1112 and 1113 each arranged on the side surface of the metal frame 1320. The second conductive pattern 1111-2 applies a signal to the second and third conductive patterns 1112 and 1113, and thus, may be referred to as a feed pattern. The feed pattern such as the second conductive pattern 1111-2 constitutes a delay line, and thus, may be referred to as a delay feeding unit.

A length of the conductive pattern 1110 may be set in units of a particular wavelength at a lowest frequency in an operating band. As an example, a length of the conductive pattern 1110 may be implemented as a length within a predetermined range based on a 1/4 wavelength with reference to 600 MHz. Meanwhile, a length from the feed point FP of the second conductive pattern 1111-2 to the ground point GP of the ground contact portion 1110g may be set as a length within a predetermined range based on a 1/4 wavelength with reference to the lowest frequency. In relation to this, the lowest frequency may be set to 600 MHz which is a lowest frequency in the LB among antenna operating bands, but is not limited thereto.

Referring to (a) of FIG. 14, the first conductive line corresponding to the second delay line 1111-2 may be connected to the third conductive pattern 1113. Referring to (b) of FIG. 14, the position P1 connected to the second conductive pattern 1111-2 may correspond to a reference position spaced apart by a predetermined gap from a position in which the ground contact portion 1110g is disposed. Referring to (c) of FIG. 14, the position P2 connected to the second conductive pattern 1111-2 may be a position obtained by moving by a gap of 10 mm from the position in which the ground contact portion 1110g is disposed toward one side. Referring to (d) of FIG. 11, the position P3 connected to the first conductive pattern 1111 may be a position obtained by moving by 30 mm from the position in which the ground contact portion 1110g is disposed toward one side.

Referring to FIGS. 14 and 15, as a position connected to the second conductive pattern 1111-2 is offset by 10 mm from the reference position, a resonant frequency in the MB shifts downward to a lower frequency. As the position connected to the second conductive pattern 1111-2 is offset by 20 mm or more from the reference position, VSWR characteristics are improved. That is, as the position connected to the second conductive pattern 1111-2 is connected is offset by 20 mm or more from the reference position, impedance matching characteristics are improved.

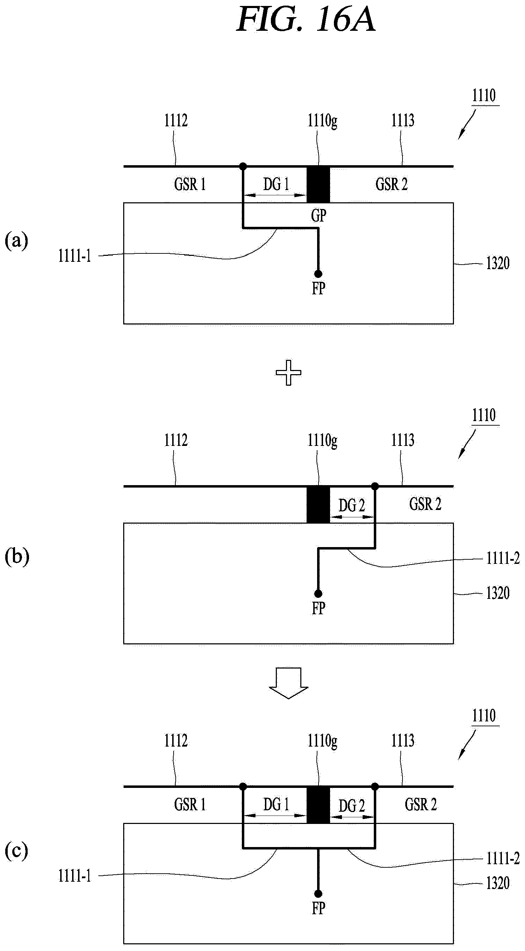

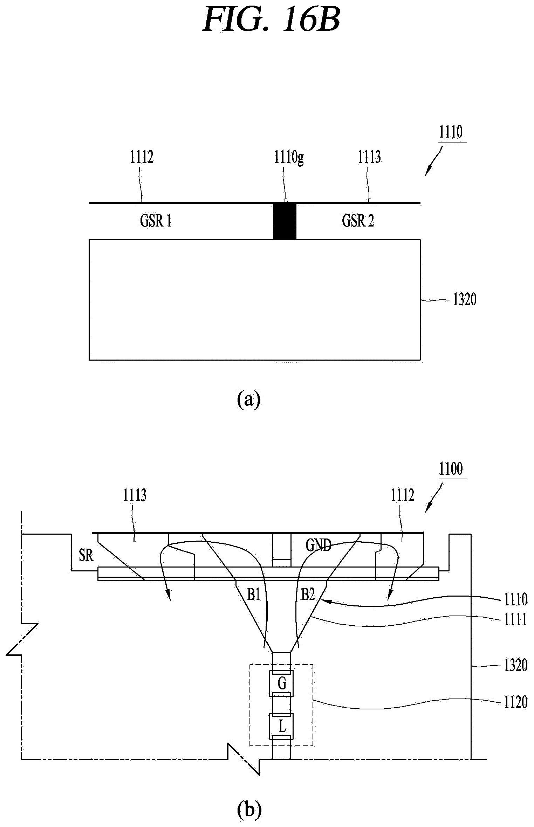

Meanwhile, the radiator structure according to the present disclosure shown in FIGS. 5A to 5C is described in comparison with a PISA structure having a delay line-type feed line of FIGS. 11 and 14. In relation to this, FIG. 16A shows a structure in which first and second delay lines are connected to a conductive pattern of the PISA structure. Meanwhile, FIG. 16B shows a process in which a first conductive pattern having a tapering shape is disposed in a slot region of the PISA structure of FIG. 16A to constitute the radiator structure of FIGS. 5B and 5C.

Referring to (a) of FIG. 16, the first conductive pattern 1111-1 corresponding to the first delay line may be connected to the second conductive pattern 1112. A first slot region GSR1 having a form of a gap may be disposed between the second conductive pattern 1112 and the metal frame 1320. The first conductive pattern 1111-1 and the ground contact portion 1110g may be arranged to be spaced apart from each other by the gap DG1, i.e., a first gap. Referring to (b) of FIG. 16A, the second conductive pattern 1111-2 corresponding to the second delay line may be connected to the third conductive pattern 1113. The second slot region GSR2 having a form of a gap may be disposed between the third conductive pattern 1113 and the metal frame 1320. The second conductive pattern 1111-2 and the ground contact portion 1110g may be arranged to be spaced apart from each other by the gap DG2, i.e., a second gap.

As shown in (c) of FIG. 16A, as the first conductive patterns 1111-1 and 1111-2 are connected to the second and third conductive patterns 1112 and 1113, respectively, the radiator structure exhibits dual resonance characteristics in the LB as shown in FIG. 9A. Accordingly, the radiator structure is a structure in which the first and second delay lines 1111-1 and 1111-2 are connected to the second and third conductive patterns 1112 and 1113 at both sides of first and second slots DSG1 and DSG2, respectively, to generate dual resonance in the LB. In addition, the first conductive pattern 1111 implemented by the first and second delay lines 1111-1 and 1111-2 may be implemented to have an inverted triangle shape of a pyramid as shown in FIG. 16B to implement wideband radiator characteristics in the MB/HB.

Referring to (a) of FIG. 16B, the metal frame 1320 is connected to a radiating conductor through the ground contact portion 1110g to define first and second slot regions GSR1 and GSR. The first slot region GSR1 is disposed between the metal frame 1320 and the second conductive pattern 1112. The second slot region GSR2 is disposed between the metal frame 1320 and the conductive pattern 1113.

The first and second delay lines 1111-1 and 1111-2 of FIG. 16B may be implemented as the first conductive pattern 1111 having an inverted triangle shape of a pyramid as shown in (b) of FIG. 16B. Referring to FIGS. 9B and 16B, a current is supplied at a first frequency in the LB from one side boundary B1 of the first conductive pattern 1111 through the third conductive pattern 1113. A current is supplied at a second frequency in the LB from another side boundary B2 of the first conductive pattern 1111 through the second conductive pattern 1112. In relation to this, the first frequency and the second frequency in the LB may be dual resonant frequencies in the LB. As an example, the first frequency and the second frequency in the LB may be 720 MHz and 920 MHz, respectively, but are not limited thereto.

Referring to FIGS. 9B and 16B, a current is supplied through the one side boundary B1 and the another side boundary B2 of the first conductive pattern 1111 in the MB and the HB. Since the first conductive pattern 1111 is implemented in an inverted triangle shape of a pyramid, dual resonance may be implemented in the LB, and a wideband radiation structure may be implemented in the MB and the HB.

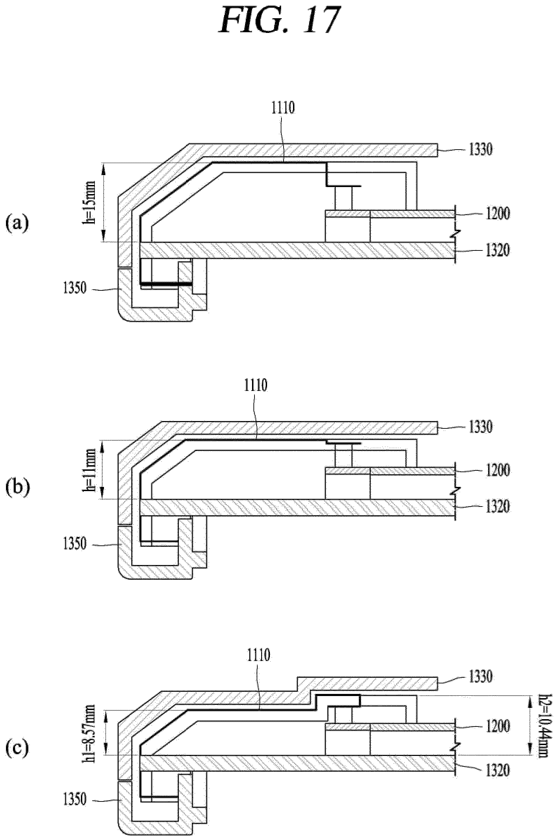

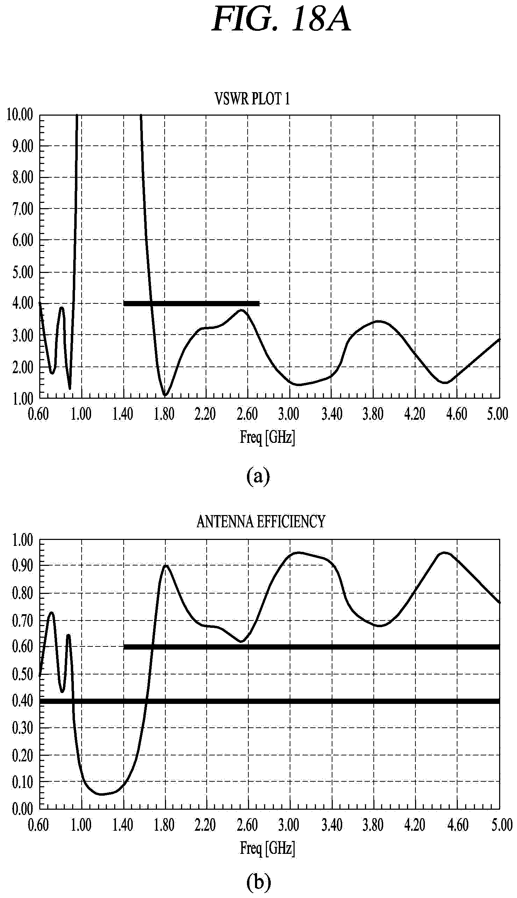

Meanwhile, in the radiator structure according to the present disclosure, antenna performance may vary depending on a height from a conductive pattern to a metal frame. In relation to this, FIG. 17 illustrates structures in which a height from a metal frame to a conductive pattern is changed in the radiator structure according to the present disclosure. Meanwhile, FIGS. 18A to 18C illustrate antenna characteristics according to a change in a height from the metal frame to the conductive pattern each shown in FIG. 17.

(a) of FIG. 17 illustrates a first structure in which a height from the metal frame 1320 to the conductive pattern 1110 is 15 mm. (b) of FIG. 17 illustrates a second structure in which a height from the metal frame 1320 to the conductive pattern 1110 is 11 mm. In the second structure, a height from the metal frame 1320 to the conductive pattern 1110 is reduced by 4 mm compared to the first structure. Accordingly, a radiator structure having a smaller thickness may be implemented in the second structure compared to the first structure.

(c) of FIG. 17 illustrates a third structure in which a height from the metal frame 1320 to the conductive pattern 1110 is 8.57 mm. In a first region PR1 of the third structure, a height from the metal frame 1320 to the conductive pattern 1110 may be configured to be 8.57 mm. In a second region PR2 of the third structure, a height from the metal frame 1320 to the conductive pattern 1110 may be configured to be 10.44 mm. In relation to this, a front surface of the inner cover 1310 may also be implemented in a form having steps so that the conductive pattern 1110 of the third structure is implemented in a form having steps.

Referring to FIG. 17 and (a) of FIG. 18A, the first structure has VSWR characteristic having a value of 4 or less in the MB, the HB, and the UHB. Referring to FIG. 17 and (b) of FIG. 18A, the first structure has antenna efficiency characteristics of 60% or more in the MB, the HB, and the UHB. Accordingly, the first structure operates as a radiator in the MB, the HB, and the UHB.

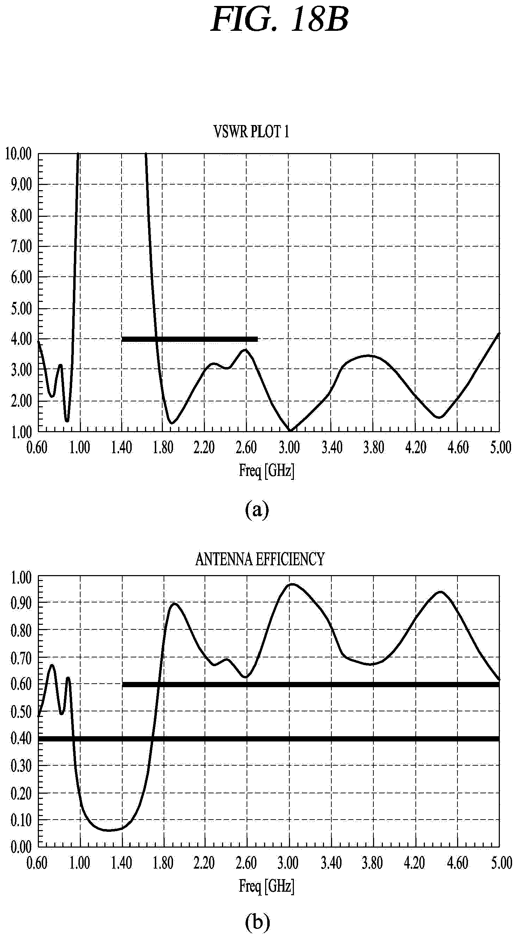

Referring to FIG. 17 and (a) of FIG. 18B, the second structure has VSWR characteristic having a value of 4 or less in the MB, the HB, and the UHB. The VSWR characteristics of the second structure are almost equivalent to those of the first structure, and, in the MB, improved compared to those of the first structure. Referring to FIG. 17 and (b) of FIG. 18B, the second structure has antenna efficiency characteristics of 60% or more in the MB, the HB, and the UHB. Antenna efficiency characteristics of the second structure are almost equivalent to the VSWR characteristics of the first structure. Accordingly, the second structure operates as a radiator in the MB, the HB, and the UHB.

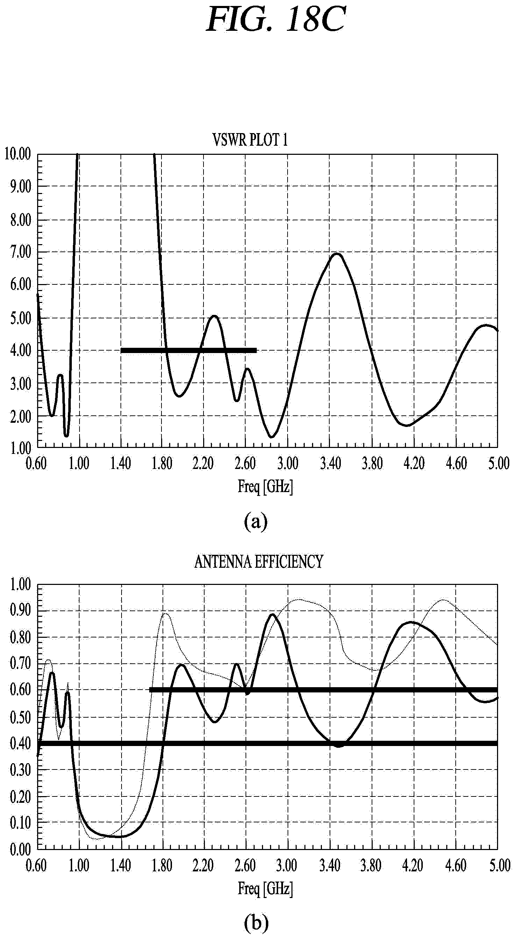

Referring to FIG. 17 and (a) of FIG. 18C, the third structure has VSWR characteristic having a value of 4 or more in some frequency bands in the MB, the HB, and the UHB. A dotted line of (b) of FIG. 18C represents antenna efficiency characteristics according to the first structure of (a) of FIG. 17, and a solid line of (b) of FIG. 18C represents antenna efficiency characteristics according to the third structure of (c) of FIG. 17.

Referring to FIG. 17 and (b) of FIG. 18C, the third structure has antenna efficiency characteristics of 60% or less in some frequency bands in the MB, the HB, and the UHB. The third structure may have antenna characteristics slightly worsened in some frequency bands of the MB, the HB, and the UHB. However, the third structure also has antenna efficiency characteristic of 40% at minimum in all bands including the MB, the HB, and the UHB.

Accordingly, in an antenna assembly implemented as a monitor module according to the present disclosure, a height from the metal frame 1320 to the conductive pattern 1110 may be determined to have a value between 8.57 mm and 15 mm. As another example, a height from the metal frame 1320 to the conductive pattern 1110 in the antenna assembly may be determined to have a value between 11 mm and 15 mm.

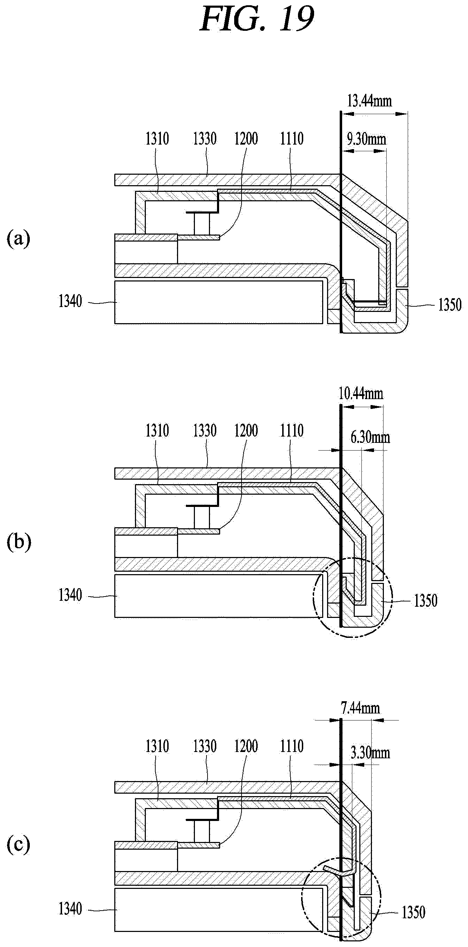

Meanwhile, in the antenna assembly according to the present disclosure, a conductive pattern needs to be apart from a metal frame by a predetermined gap or more to secure antenna characteristics. Additionally, in the antenna assembly, the metal frame needs to be spaced apart from a front cover accommodating the conductive pattern and defining a side surface end by a predetermined gap or more. In relation to this, FIG. 19 illustrates structures in which a gap from a metal frame to a conductive pattern or a front cover is changed according to embodiments.

(a) of FIG. 19 illustrates a first structure corresponding to a reference structure. The antenna assembly having the first structure is a structure in which the conductive pattern 1110 is spaced apart from a metal frame 1020 by 9.3 mm toward an outer region to secure antenna characteristics. Referring to FIGS. 5B, 5C, 8A, and 8B, and (a) of FIG. 19, one side region of the conductive pattern 1110 is disposed to be spaced apart from a side surface region of the metal frame 1020 by 9.3 mm toward an outer region. One end portion of the conductive pattern 1110 may be connected to a feeding portion of the PCB 1200. Another end portion of the conductive pattern 1110 may be connected to the metal frame 1320. The front cover 1350 and/or the outer cover 1330 accommodated by the conductive pattern 1110 and defining a side surface end may be spaced apart from the metal frame 1320 by 13.44 mm toward an outer region.

The second structure of (b) of FIG. 19 is a structure in which a space of a side surface region is reduced compared to the first structure of (a) of FIG. 19. The second structure is a structure in which the conductive pattern 1110 is spaced apart from the metal frame 1020 by 6.3 mm toward an outer region. Therefore, the second structure is a structure in which the conductive pattern 1110 is spaced apart by about 3 mm toward an inner region, compared to the first structure. Accordingly, a length of the conductive pattern in the second structure may be configured to have a smaller length than a length of the conductive pattern in the first structure.

Referring to FIGS. 5B, 5C, 8A, and 8B, and (b) of FIG. 19, one side region of the conductive pattern 1110 is disposed to be spaced apart from a side surface region of the metal frame 1020 by 6.3 mm toward an outer region. One end portion of the conductive pattern 1110 may be connected to a feeding portion of the PCB 1200. Another end portion of the conductive pattern 1110 may connected to the metal frame 1320. The front cover 1350 accommodated by the conductive pattern 1110 and defining a side surface end may be spaced apart from the metal frame 1320 by 10.44 mm to an outer region. Thus, the second structure is a structure in which the front cover 1350 and/or the outer cover 1330 are spaced apart by about 3 mm toward an inner region, compared to the first structure. Accordingly, the antenna assembly having the second structure may be configured to have a smaller size than that of the antenna assembly having the first structure. In relation to this, a front surface 1321 of the front cover 1350 supporting the display module 1340 may constitute a bezel. Compared to the first structure, a length of the bezel corresponding to the front surface 1351 of the front cover 1350 may be reduced in the second structure.

A third structure of (c) of FIG. 19 is a structure in which a space of a side surface region is reduced, compared to the second structure of (b) of FIG. 19. The third structure is a structure in which the conductive pattern 1110 is spaced apart from the metal frame 1020 by 3.3 mm toward an outer region. Thus, the third structure is a structure in which the conductive pattern 1110 is spaced apart by about 3 mm toward an inner region, compared to the second structure. Accordingly, a length of the conductive pattern in the third structure may be configured to have a smaller length than a length of the conductive pattern in the second structure.

Referring to FIGS. 5B, 5C, 8A, and 8B, and (c) of FIG. 19, one side region of the conductive pattern 1110 is disposed to be spaced apart from a side surface region of the metal frame 1020 by 3.3 mm toward an outer region. One end portion of the conductive pattern 1110 may be connected to a feeding portion of the PCB 1200. Another end portion of the conductive pattern 1110 may connected to the metal frame 1320.

In the third structure of (c) of FIG. 19, the front cover 1350 accommodated by the conductive pattern 1110 and defining a side surface end may be spaced apart from the metal frame 1320 by 7.44 mm toward an outer region. The third structure is a structure in which the front cover 1350 and/or the outer cover 1330 are spaced apart by about 3 mm toward an inner region, compared to the second structure. Accordingly, the antenna assembly having the third structure may be configured to have a smaller size than that of the antenna assembly having the second structure. Compared to the second structure, a length of the bezel corresponding to the front surface 1321 of the front cover 1350 may be reduced in the third structure. The third structure may be a structure implemented to have a minimum bezel length that may be mechanically implemented. Accordingly, the third structure may be regarded as a structure to which a side surface pattern is not applied.

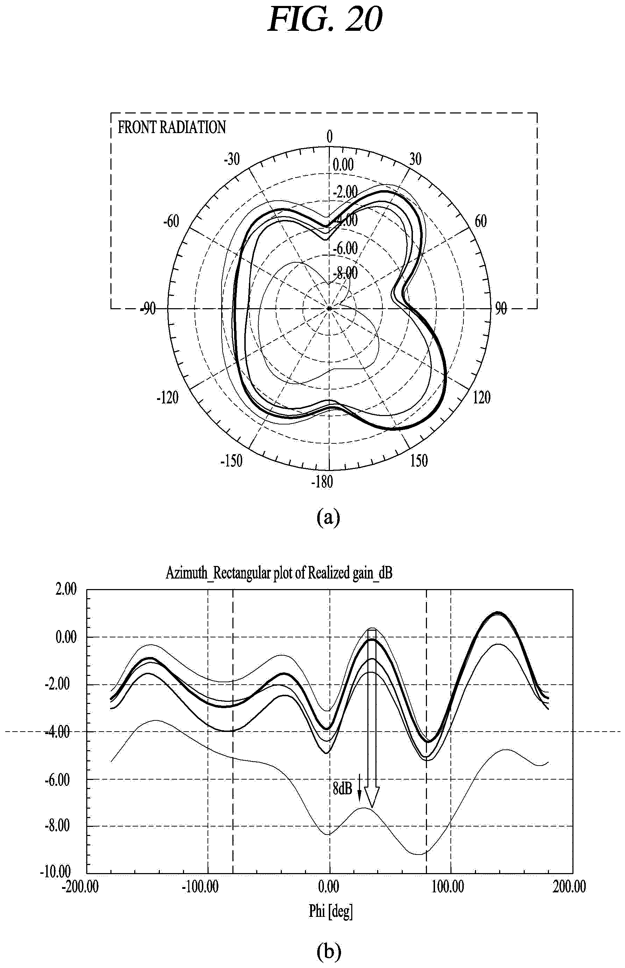

Meanwhile, FIG. 20 shows antenna radiation characteristics according to a change in a gap from the metal frame to the conductive pattern each shown in FIG. 19. (a) of FIG. 20 shows antenna radiation characteristics expressed in polar coordinates. (b) of FIG. 20 shows antenna radiation characteristics expressed in Cartesian coordinates.

Referring to FIG. 20, a radiation pattern according to movement of the conductive pattern by 1 mm inwardly with respect to a reference structure, i.e., the first structure, and a radiation pattern of the third structure regarded as a structure to which a side surface pattern is not applied are shown. Accordingly, FIG. 20 shows antenna radiation patterns of the first structure, the second structure, and the third structure, respectively, and radiation patterns in cases when the conductive pattern is moved inwardly by 1 mm and 2 mm, respectively, compared to the first structure. Accordingly, FIG. 20 shows radiation patterns in cases when a conductive pattern (or a front cover) is moved inwardly by 1 mm, 2 mm, 3 mm, and 6 mm, respectively, compared to the first structure, i.e., the reference structure.

Referring to FIGS. 19 and 20, in the first structure and the second structure, front radiation characteristics are maintained at a certain level or higher in a front region of a monitor structure. In relation to this, in cases when the conductive pattern (or the front cover) is moved inwardly by 1 mm, 2 mm, and 3 mm compared to the first structure, a gain value of about -4 dB or more is obtained. On the other hand, a gain value of the third structure in which the conductive pattern (or the front cover) is moved inwardly by 6 mm is -4 dB or less in a whole front region. The gain value of the third structure has a performance about 25% lower than a target gain value of -4 dB. The gain value of the third structure is about 8 dB lower than that of the first structure.

To compensate for such performance deterioration, the conductive pattern (or the front cover) may be disposed to have a larger gap than that in the third structure, or a shape or thickness of the inner cover 1310 may be changed. In addition, a dielectric structure may be disposed in spaces between the inner cover 1310, the outer cover 1320, and the front cover 1350 to improve front radiation characteristics.

Meanwhile, in the antenna assembly having a radiation structure disclosed herein, a space in which the conductive pattern 1110 is to be arranged needs to be secured by configuring a bezel length of the front cover 1350 constituting a front mechanism to be greater than a critical value. Depending on presence of an antenna pattern such as the conductive pattern 1110 on a side surface of the display module 1340, a performance deviation such as an antenna gain of about 8 dB occurs.

Accordingly, to maintain performance such as an antenna gain at a certain level or higher, one side region of the conductive pattern 1110 may be disposed to be spaced apart from a side surface region of the metal frame 1020 outwardly by 6.3 mm to 9.3 mm. In relation to this, to maintain antenna performance at a certain level or greater, the conductive pattern 1110 needs to be spaced apart from the metal frame 1020 by 6.3 mm or more. However, to implement a bezel length of the display module 1340 at a certain level or lower, the conductive pattern 1110 needs to be spaced apart from the metal frame 1020 by 9.3 mm or less. In relation to this, the front cover 1350 and/or the outer cover 1330 need to be spaced apart from the metal frame 1320 by 10.44 mm to 13.44 mm toward an outer region.

Meanwhile, an antenna assembly having a monitor structure mounted on a rear seat of a vehicle disclosed herein may be implemented as a plurality of antennas to support MIMO operation. In relation to this, FIG. 20 illustrates a plurality of antennas arranged inside an outer cover of the antenna assembly implemented as the monitor structure.

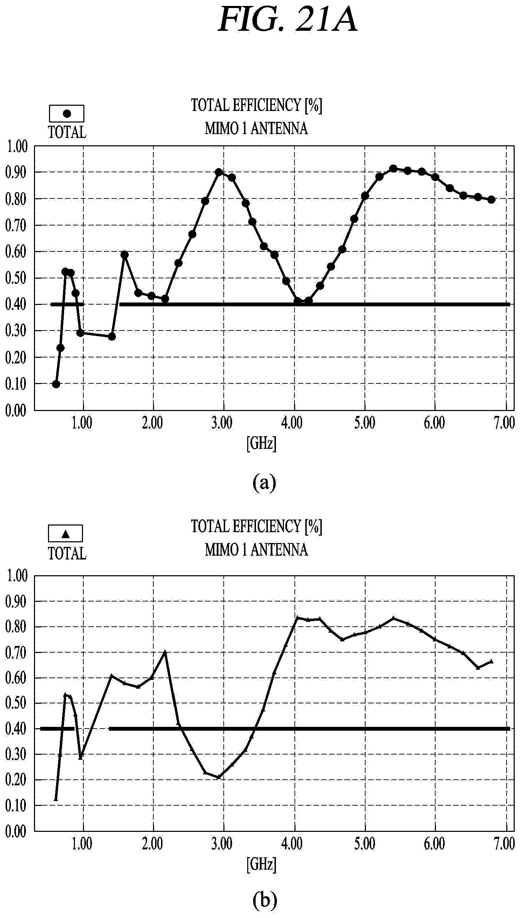

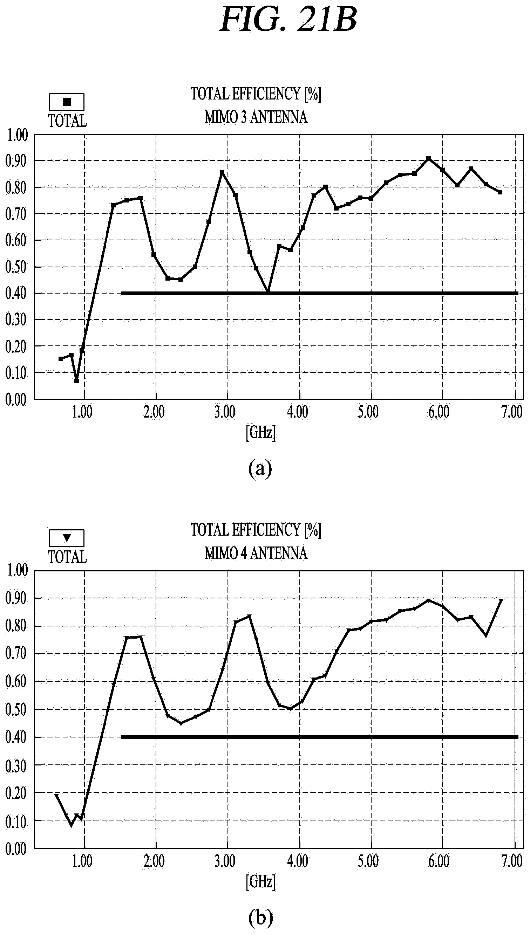

Referring to FIGS. 7, 10, and 20, the first antenna 1100a and the second antenna 1100b positioned on one side surface and another side surface inside the outer cover 1320, respectively, may be designed to optimize antenna characteristics in the LB. In relation to this, FIGS. 21A and 21B illustrate gain characteristics of the first to fourth antennas of FIG. 10. (a) of FIG. 21A, (b) of FIG. 21A, (a) of FIG. 21B, and (b) of FIG. 21B show gain characteristics of the first antenna, the second antenna, the third antenna, and the fourth antenna, respectively.

Referring to FIGS. 7 and 10, and (a) and (b) of FIGS. 21A, the first antenna 1100a and the second antenna 1100b have antenna efficiency of 40% or more in the LB. However, the first antenna 1100a and the second antenna 1100b have antenna efficiencies of different values in the MB and the HB. In this regard, the second antenna 1100b has an antenna efficiency of 40% or less in the MB and the HB.

Since the antenna assembly including the first antenna 1100a and the second antenna 1100b is installed in one of rear seats in the vehicle, a surrounding environment of the first antenna 1100a is configured to be different from that of the second antenna 1100b. Accordingly, efficiency characteristics of the first antenna 1100a and the second antenna 1100b may be different from each other. Alternatively, the first antenna 1100a and the second antenna 1100b may be designed to have different structures or dimensions to minimize an interference therebetween. The impedance matching portion 1120 of FIG. 5C may be implemented in the first antenna 1100a differently from in the second antenna 1100b. In this regard, a capacitance of a capacitor connected to a feeding portion of the first antenna 1100a may be set to 3 pF. Meanwhile, a capacitance of a capacitor connected to the feeding portion of the second antenna 1100b may be set to 2 pF.

Referring to FIGS. 7 and 10 and (a) and (b) of FIG. 21B, the third antenna 1100c and the fourth antenna 1100d have antenna efficiencies of 40% or less in the LB. The third antenna 1100c and the fourth antenna 1100d have antenna efficiencies of 40% or more in the MB, the HB, and the UHB. The third antenna 1100c and the fourth antenna 1100d may be controlled not to operate as a radiator in the LB. In relation to this, since the third antenna 1100c and the fourth antenna 1100d do not operate in the LB, a gap between the third antenna 1100c and the fourth antenna 1100d may be configured to be smaller than a gap between the first antenna 1100a and the second antenna 1100b.

As described above, the third antenna 1100c and the fourth antenna 1100d may be implemented to operate only in the MB, the HB, and the UHB. Accordingly, a processor of the antenna assembly may perform 2X2 MIMO operation 1100b through the first antenna 1100a and the second antenna in the LB. Meanwhile, the processor may perform a maximum of 4X4 MIMO operation through the first antenna 1100a to the fourth antenna 1100d in the MB, the HB, and the UHB. The processor may be implemented as the NAD 1400 of FIG. 10.

The processor may perform 2X2 MIMO operation in the MB, the HB, and the UHB. In relation to this, the processor may perform 2X2 MIMO operation through the third antenna 1100c and the fourth antenna 1100d in the MB, the HB, and the UHB. The processor may perform 2X2 MIMO operation through the first antenna 1100a and the second antenna 1100b in the LB. While performing 2X2 MIMO operation through the first antenna 1100a and the second antenna 1100b in the LB, the processor may perform 2X2 MIMO operation through the third antenna 1100c and the fourth antenna 1100d in at least one of the MB, the HB, and the UHB.

The antenna assembly for a vehicle according to one aspect of the present disclosure has been described. Hereinafter, a vehicle including an antenna assembly for a vehicle according to another aspect of the present disclosure is to be described. In relation to this, the description about all the aforementioned configurations and technical features may also be applied to a vehicle having an antenna assembly for a vehicle which will be described hereinafter.

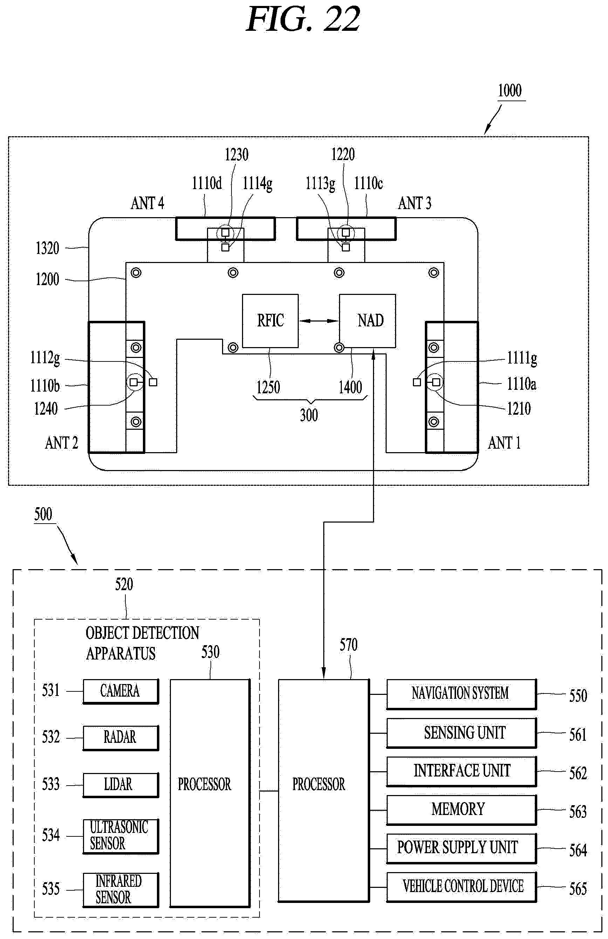

Meanwhile, FIG. 22 is a block diagram illustrating an antenna assembly according to an embodiment and a vehicle on which the antenna assembly is mounted. Specifically, FIG. 22 is a block diagram of a vehicle illustrating that an antenna assembly corresponding to an antenna assembly is mounted inside a roof of the vehicle to perform communications with adjacent electronic devices, vehicles, and infrastructures.

Referring to FIGS. 4 and 22, the antenna system 1000 may be mounted on a vehicle, and the antenna system 1000 may perform short-range communication, wireless communication, V2X communication, etc. independently or through the communication device 400. To this end, the baseband processor 1400 may perform control such that a signal is received from or transmitted to the adjacent vehicle, the RSU, and the base station through the antenna assembly 1000.

Alternatively, the baseband processor 1400 may perform control such that a signal is received from or transmitted to the adjacent vehicle, the RSU, the adjacent object, and the base station. Here, the information related to adjacent objects may be acquired through the object detection device such as the camera 531, the radar 532, the LiDar 533, and the sensors 534 and 535 of the vehicle 500. Alternatively, the baseband processor 1400 may perform control such that a signal is received from or transmitted to the adjacent vehicle, the RSU, the adjacent object, and the base station through the antenna assembly 1000.

Meanwhile, referring to FIGS. 1A to 22, the vehicle 500 having the antenna assembly 1000 may include the plurality of antennas 1100, the transceiver circuit 1250, and the baseband processor 1400. The transceiver circuitry 1250 and/or the processor 1400 may be disposed in the communication module 300. The transceiver circuit 1250 may be partially implemented in each of the plurality of antennas 1100a to 1100d or included in the NAD 1400.

The vehicle 500 may further include the object detection device 520. The vehicle 500 may further include the communication device 400. Here, the communication device 400 may be configured to perform wireless communication through the antenna assembly 1000.

The vehicle 500 may include a conductive vehicle body that operates as an electrical ground. The vehicle 500 may include a plurality of antennas 1100a to 1100d. The antenna assembly 1000 may be configured such that the plurality of antennas 1100a to 1100d include a communication module 300. The communication module 300 may include a transceiver circuit 1250 and a processor 1400. The communication module 300 may correspond to the TCU of the vehicle or may constitute at least a portion of the TCU.

The vehicle 500 may include an object detection device 520 and a navigation system 550. The vehicle 500 may further include a separate processor 570 in addition to the processor 1400 included in the communication module 300. The processor 1400 and the separate processor 570 may be physically or functionally separated and implemented on one substrate. The processor 1400 may be implemented as a TCU, and the processor 570 may be implemented as an electronic control unit (ECU).

In case where the vehicle 500 is an autonomous vehicle, the processor 570 may be an autonomous driving control unit (ADCU) integrated with an ECU. Based on information detected through the camera 531, radar 532, and/or lidar 533, the processor 570 may search for a path and control the speed of the vehicle 500 to accelerate or decelerate. To this end, the processor 570 may interoperate with the processor 530 corresponding to the MCU in the object detection device 520 and/or the communication module 300 corresponding to the TCU.

In the vehicle 500 may be provided with the antenna assembly 1000. The antenna assembly 1000 may be disposed on the bottom of the roof of the vehicle, and perform communication with at least one of an adjacent vehicle, a Road Side Unit (RSU), and a base station through the processor. Since the antenna assembly 1000 performs telematics operations through wireless communication in the vehicle, it may also be referred to as a telematics module. In this regard, the second PCB 1200 in the antenna assembly 1000 may be coupled with the first PCB 1200b that performs a telematics function. In this regard, the second PCB 1200 and the first PCB 1200b may be combined to interface with each other on the same plane.

Hereinafter, a vehicle 500 having an antenna assembly 1000 according to another aspect of the present disclosure will be described, with reference to FIGS. 1A to 22. The vehicle 500 may include an antenna assembly 1000 disposed below the roof of the vehicle. The vehicle 500 may further include the processor 1400 disposed inside or outside the antenna assembly 1000 and configured to communicate with at least one of an adjacent vehicle, a road side unit (RSU), and a base station.

In relation to this, the antenna assembly 1000 may include the inner cover 1310 made of a dielectric material and having the front surface 1311, and the one side surface 1312 and the another side surface 1313 each extending from the front surface. The antenna assembly 1000 may include the conductive pattern 1110 disposed to extend from the feed point FP on the front surface of the inner cover 1310 to one side surface of the inner cover 1310. The conductive pattern 1110 may be configured to have a tapering shape from the one side surface 1312 toward the feed point FP on the front surface 1311 to transmit or receive a wireless signal. The antenna assembly 1000 may include the metal frame 1320 disposed to be in contact with one point of the conductive pattern 1110 to connect the conductive pattern 1110 to ground at the one point.

The antenna assembly 1000 may include the outer cover 1330 coupled to the inner cover 1310. The antenna assembly 1000 may include the slot regions SR1 and SP2 disposed between the conductive pattern 1110 and the metal frame 1320.

The antenna assembly 1000 may include the front module 1350 including the front surface 1351, the inner side surface 1352, and the outer side surface 1353, and configured to support the display module 1340 through the inner side surface 1352. The front module 1350 may be disposed so that the metal frame 1320 and the conductive pattern 1310 are arranged in a space between the inner side surface 1352 and the outer side surface 1353.

The conductive pattern 1110 may extend from both end portions of the one side surface 1312 to the front surface 1311 to define the first end point FP1 and the second end point FP2. The first end point FP1 of the conductive pattern 1110 may be disposed to be curved toward the feed point FP. The second end point FP2 of the conductive pattern 1110 is disposed to be curved toward the feed point FP so that the conductive pattern 1110 may be configured to transmit or receive a wideband wireless signal.

The transceiver circuitry 1250 may be operably coupled to each radiator module 1100. The processor 1400 may be operably coupled to the transceiver circuity 1250. The processor 1400 may be a baseband processor corresponding to a modem, but is not limited thereto and may be any processor that controls the transceiver circuity 1250. The processor 1400 of the vehicle may be implemented as a network access device (NAD) and may be referred to as a wireless communication control IC.

The transceiver circuitry 1250 may be operably coupled to the MIMO antennas ANT1 to ANT4. The transceiver circuitry 1250 may include a front end module (FEM) such as a power amplifier or a receiving amplifier. As another example, the front end module (FEM) may be disposed between the transceiver circuitry 1250 and the antenna, separately from the transceiver circuitry 1250. The transceiver circuitry 1250 may control the amplitude and/or phase of signals transmitted to the MIMO antennas ANT1 to ANT4 or control only some antenna modules to operate by adjusting the gain or input or output power of the power amplifier or the receiving amplifier.

The processor 1400 may be operably coupled to the transceiver circuitry 1250 and may be configured to control the transceiver circuitry 1250. The processor 1400 may control the transceiver circuitry 1250 to control the amplitude and/or phase of the signals transmitted to the MIMO antennas ANT1 to ANT4 or to operate only some antenna modules. The processor 1400 may perform communication with at least one of the adjacent vehicle, the RSU, and the base station through the transceiver circuitry 1250.

In a case where there is a need to simultaneously receive information from various entities such as the adjacent vehicle, the RSU, and the base station for autonomous driving, etc., information may be received and transmitted through MIMO. Accordingly, the vehicle may improve its communication capacity by receiving different information from various entities at the same time. Therefore, the communication capacity of the vehicle can be improved through the MIMO without increasing a bandwidth.

Alternatively, the vehicle may simultaneously receive the same information from various entities, so as to improve reliability of surrounding information and decrease latency. Accordingly, ultra reliable low latency communication (URLLC) can be performed in the vehicle and the vehicle can operate as a URLLC UE. To this end, a base station that performs scheduling may preferentially allocate a time slot for the vehicle operating as the URLLC UE. For this, some of specific time-frequency resources already allocated to other UEs may be punctured.

As described above, the plurality of antennas ANT1 to ANT4 for 4G/5G communication within the antenna module 1000 may operate in the full band including the low band (LB), the mid band (MB), and the high band (HB). Here, the low band (LB) may be referred to as the first (frequency) band and the mid band (MB) and the high band (HB) may be referred to as the second (frequency) band. As another example, when the antenna system 1000 operates in the mid band (MB) and the high band (HB), the middle band (MB) is referred to as a first (frequency) band and the high band (HB) is referred to as a second (frequency) band. The 5G Sub6 band may be the same band as the LTE band in case of LTE re-farming. When 5G NR operates in a band separate from LTE, it may operate in the high band (HB) or a higher band. The 5G Sub6 band operating in the high band (HB) or higher band may also be referred to as a second (frequency) band.

The baseband processor 1400 may perform MIMO through some of the plurality of antennas ANT1 to ANT4 in the first frequency band. Also, the baseband processor 1400 may perform MIMO through some of the plurality of antennas ANT1 to ANT4 in the second frequency band. In this regard, the baseband processor 1400 may perform MIMO by using antenna elements that are sufficiently spaced apart from each other and disposed by being rotated at a predetermined angle. This may improve isolation between the first and second signals within the same band.

The baseband processor 1400 may control the transceiver circuitry 1250 to receive the second signal of the second frequency band while receiving the first signal of the first frequency band through one of the first to fourth radiators ANT1 to ANT4. In this case, there may be an advantage that the baseband processor 1400 can perform carrier aggregation (CA) through one antenna.

Alternatively, the baseband processor 1400 may control the transceiver circuitry 1250 to receive the first signal of the second band through any one of the third radiator ANT3 and the fourth radiator ANT4 while receiving the first signal of the first band through any one of the first radiator ANT1 and the third radiator ANT2. In this case, there may be an advantage in that each antenna can be designed to optimally operate in a corresponding band.

Therefore, the baseband processor 1400 may perform carrier aggregation (CA) through a combination of the first frequency band and the second frequency band. When it is necessary to receive a large amount of data for autonomous driving or the like, reception in a broad band can be allowed through the CA.

Accordingly, enhanced mobile broad band (eMBB) communication may be performed in the vehicle and the vehicle can operate as an eMBB UE. To this end, a base station performing scheduling may preferentially allocate broadband frequency resources for the vehicle operating as the eMBB UE. To this end, the CA may be performed on frequency bands that are available, except for frequency resources already allocated to other UEs.

Regard the frequency band, the low band (LB), the mid band (MB), and the high band (HB) may be referred to as the first band, the second band, and the third band, respectively. The antenna system 1000 may operate as a single antenna in the first band, the second band, and the third band corresponding to the low band (LB), the middle band (MB), and the high band (HB). In this regard, the processor 1400 may determine a resource region allocated through a physical downlink control channel (PDCCH). The processor 1400 may control the transceiver circuitry 1250 to perform carrier aggregation in two or more of the first to third bands based on the allocated resource region.

The processor 1400 may perform MIMO in an EN-DC state through the first to fourth radiators ANT1 to ANT4. For example, the processor 1400 may perform an EN-DC operation through the first radiator ANT1 and the second radiator ANT2, and MIMO through the third radiator ANT3 and the fourth radiator ANT4.

In this regard, when the EN-DC operation is performed between 4G and 5G communication systems using different bands, the processor 1400 may perform the EN-DC operation through a plurality of antennas in one antenna system. Accordingly, an interference level between MIMO streams using the same band can be reduced. In some examples, when the EN-DC operation is performed between the 4G and 5G communication systems using the same band, the processor 1400 may perform the EN-DC operation through a plurality of antennas in different antenna systems. In this instance, to reduce the interference level in the low band (LB), the MIMO operation through the plurality of antennas in the same antenna system may be performed in the mid band (MB) or higher.

It will be clearly understood by those skilled in the art that various modifications and alternations for the aforementioned implementations related to the antenna system having the plurality of antennas, the vehicle having the antenna system, and the control operations thereof are made without departing from the idea and scope of the disclosure. Therefore, it should be understood that such various modifications and alternations for the implementations fall within the scope of the appended claims.

In the above description, an antenna assembly having a wideband antenna mounted on a vehicle and a vehicle on which the antenna assembly is mounted have been described. Hereinafter, technical effects of an antenna assembly having a wideband antenna mounted on such a vehicle and a vehicle on which the antenna assembly is mounted are described.

According to the present disclosure, an antenna assembly in which a plurality of antennas for 4G/5G communication are arranged through a slot structure in a module having a metal frame disposed therein may be placed in a vehicle.

According to the present disclosure, an antenna element operating as a radiator in a wide band such as the LB, the MB, the HB, and the UHB for 4G/5G communications may be implemented by configuring an antenna pattern operating in a slot structure and by a dual mode.

According to the present disclosure, a radiator structure for improving antenna characteristics in the LB may be configured through a radiator structure in a dual mode using a dual feed method.

According to the present disclosure, 4G/5G wireless communication may be provided in a vehicle by disposing at least one antenna element in an inner cover made of a dielectric material and defining a slot structure with a peripheral metal frame inside a monitor structure installed in a rear seat of a vehicle.

According to the present disclosure, as antenna elements are arranged on one side and another side within a limited region of an antenna assembly having a monitor structure, an antenna arrangement structure for minimizing an interference between the antenna elements may be provided.

According to the present disclosure, as antenna element are arranged on a left side and a right side in a limited region of an antenna assembly, an antenna arrangement structure for minimizing an interference between the antenna elements may be provided.

Another object of the present disclosure is to provide a structure for mounting an antenna assembly capable of operating in a wide band to support various communication systems inside a rear seat monitor structure of a vehicle.

Further scope of applicability of the disclosure will become apparent from the foregoing detailed description. It should be understood, however, that the detailed description and specific examples, such as the preferred embodiment of the disclosure, are given by way of illustration only, since various modifications and alternations within the spirit and scope of the disclosure will be apparent to those skilled in the art.

In relation to the foregoing description, the antenna system mounted in the vehicle and the operation of controlling the same may be implemented by software, firmware, or a combination thereof. Meanwhile, the design of the antenna system mounted in the vehicle and the configuration of controlling the antenna system may be implemented as computer-readable codes in a programrecorded medium. The computer-readable medium may include all types of recording devices each storing data readable by a computer system. Examples of such computer-readable media may include hard disk drive (HDD), solid status disk (SSD), silicon disk drive (SDD), ROM, RAM, CD-ROM, magnetic tape, floppy disk, optical data storage element and the like. Also, the computer-readable medium may also be implemented as a format of carrier wave (e.g., transmission via an Internet). The computer may also include a controller of a terminal or vehicle, namely, a processor. Therefore, the detailed description should not be limitedly construed in all of the aspects, and should be understood to be illustrative. The scope of the disclosure should be determined by reasonable interpretation of the appended claims and all changes that come within the equivalent scope of the disclosure are included in the scope of the disclosure.

## Claims

1. An antenna assembly mounted on a vehicle, the antenna assembly comprising:
an inner cover made of a dielectric material and having a front surface, and one side surface and another side surface each extending from the front surface;
a conductive pattern disposed to extend from a feed point on the front surface of the inner cover to the one side surface of the inner cover, the conductive pattern being configured to have a tapering shape from the one side surface toward the feed point on the front surface to transmit or receive a wireless signal;
a metal frame disposed to be in contact with one point in the conductive pattern to allow the conductive pattern to be connected to ground at the one point;
an outer cover coupled to the inner cover; and
a slot region disposed between the conductive pattern and the metal frame,
wherein the conductive pattern extends from both end portions of the one side surface to the front surface to define a first end point and a second end point, and
the first end point of the conductive pattern is disposed to be curved toward the feed point and the second end point of the conductive pattern is disposed to be curved toward the feed point so that the conductive pattern transmits or receives a wideband wireless signal.

2. The antenna assembly of claim 1, wherein the conductive pattern comprises:
a first conductive pattern configured to have a tapering shape from the one side surface of the inner cover toward the feed point on the front surface of the inner cover;
a second conductive pattern extending from a first end portion of the one side surface to the front surface to define the first end point; and
a third conductive pattern extending from a second end portion of the one side surface to the front surface to define the second end point,
wherein the first end point of the second conductive pattern is disposed to be curved toward the feed point, and the second end point of the third conductive pattern is disposed to be curved toward the feed point.

3. The antenna assembly of claim 1, wherein the inner cover further comprises an inclined region disposed to be inclined between the front surface and the one side surface,
the first conductive pattern comprises:
a first sub-pattern disposed on the front surface of the inner cover to have a tapering shape and having a feed point at an end portion;
a second sub-pattern disposed on the inclined region of the inner cover to have a tapering shape; and
a third sub-pattern disposed on the one side surface of the inner cover to have a first width and a first length,
a distance between points connecting from the second sub-pattern to the third sub-pattern is configured as a second width smaller than the first width, and
a distance between points connecting from the first sub-pattern to the second sub-pattern is configured to as a third width smaller than the second width.

4. The antenna assembly of claim 3, wherein the second conductive pattern is connected to the third sub-pattern in the inclined region of the inner cover, and the first end point is disposed to be curved inwardly toward the feed point, and
the third conductive pattern is connected to the third sub-pattern in the inclined region of the inner cover, and the second end point is disposed to be curved inwardly toward the feed point.

5. The antenna assembly of claim 3, wherein the second conductive pattern is disposed in a first end portion of the first conductive pattern to have a fourth width, and spaced apart from the second sub-pattern by a first gap,
the third conductive pattern is disposed in a second end portion of the first conductive pattern to have a fifth width, and spaced apart from the second sub-pattern by a second gap, and
a sum of the second width, the fourth width, the fifth width, the first gap, and the second gap is identical to the first width.

6. The antenna assembly of claim 2, wherein an antenna according to the conductive pattern may be configured to operate in a low band (LB), a mid-band (MB), a high band (HB), and an ultra-high band (UHB) for fourth generation (4G) wireless communication and fifth generation (5G) wireless communication, and
the antenna is configured to:
radiate a wireless signal at a first frequency in the low band (LB), as a current is supplied through the first conductive pattern and the third conductive pattern,
radiate a wireless signal at a second frequency in the low band (LB), as a current is supplied through the first conductive pattern and the second conductive pattern, and
the third conductive pattern has a larger area than an area of the second conductive pattern.

7. The antenna assembly of claim 6, wherein the antenna is configured to:
radiate a wireless signal in the mid-band (MB) and the high band (HB), as a current is supplied through boundary regions on both sides of the tapering shape of the first conductive pattern, and
radiate a wireless signal in the ultra-high band (UHB) as a current is supplied through an inner region of the tapering shape of the first conductive pattern.

8. The antenna assembly of claim 1, further comprising a printed circuit board (PCB) connected, at the feed point, to the conductive pattern disposed on the front surface of the inner cover, and disposed between the metal frame and the outer cover,
wherein the PCB has a feed pattern disposed thereon to be connected to the feed point of the conductive pattern.

9. The antenna assembly of claim 8, further comprising:
a ground contact portion disposed between the PCB and the metal frame so that the conductive pattern disposed on the one side surface of the inner cover is in contact with the metal frame; and
a display module fixed to the metal frame and configured to display screen information,
wherein the metal frame is a display frame configured to support the display module.

10. The antenna assembly of claim 9, further comprising a front cover comprising a front surface, an inner side surface, and an outer side surface, disposed to support the display module through the inner side surface, and configured such that the metal frame and the conductive pattern are placed in a space between the inner side surface and the outer side surface,
wherein the slot region disposed between the conductive pattern and the metal frame is disposed on the inner side surface of the front cover.

11. The antenna assembly of claim 8, wherein the antenna assembly is disposed inside a rear seat monitor module disposed in a rear seat of a vehicle, and performs wireless communication within the vehicle and wireless communication between the vehicle and another vehicle or a wireless entity outside the vehicle.

12. The antenna assembly of claim 11, wherein the antenna assembly comprises a first antenna and a second antenna arranged on a left side and a right side of the rear seat monitor module, respectively, and a third antenna and a fourth antenna arranged on an upper left side and an upper right side of the rear seat monitor module, respectively, and
the first antenna is positioned in a further left region compared to the third antenna, and the second antenna is positioned in a further right region compared to the fourth antenna.

13. The antenna assembly of claim 12, further comprising a network access device (NAD) disposed on the PCB and coupled to the first antenna to the fourth antenna to control to perform multiple input/output (MIMO) operation through the first antenna to the fourth antenna,
wherein the NAD and the first antenna to the fourth antenna are connected to each other via a coaxial cable.

14. An antenna assembly mounted on a vehicle, the antenna assembly comprising:
a display module;
an inner cover made of a dielectric material and having a front surface, and one side surface and another side surface each extending from the front surface;
a conductive pattern disposed to extend from a feed point on the front surface of the inner cover to the one side surface of the inner cover, the conductive pattern being configured to have a tapering shape from the one side surface toward the feed point on the front surface to transmit or receive a wireless signal;
a metal frame disposed to surround a rear surface and side surfaces of the display module;
a front cover comprising a front surface, an inner side surface, and an outer side surface, disposed to support the display module through the inner side surface, and configured such that the metal frame and the conductive pattern are disposed in a space between the inner side surface and the outer side surface;
an outer cover coupled to the inner cover; and
a slot region disposed between the conductive pattern and the metal frame,
wherein the conductive pattern extends from both end portions of the one side surface to the front surface to define a first end point and a second end point, and
the first end point of the conductive pattern is disposed to be curved toward the feed point and the second end point of the conductive pattern is disposed to be curved toward the feed point so that the conductive pattern transmits or receives a wideband wireless signal.

15. The antenna assembly of claim 14, wherein the conductive pattern comprises:
a first conductive pattern configured to have a tapering shape from the one side surface of the inner cover toward the feed point on the front surface of the inner cover;
a second conductive pattern extending from a first end portion of the one side surface to the front surface to define the first end point; and
a third conductive pattern extending from a second end portion of the one side surface to the front surface to define the second end point,
wherein the first end point of the second conductive pattern is disposed to be curved toward the feed point, and the second end point of the third conductive pattern is disposed to be curved toward the feed point.

16. The antenna assembly of claim 15, wherein the inner cover further comprises an inclined region disposed to be inclined between the front surface and the one side surface,
the conductive pattern comprises:
a first sub-pattern disposed on the front surface of the inner cover to have a tapering shape and having a feed point at an end portion;
a second sub-pattern disposed on the inclined region of the inner cover to have a tapering shape; and
a third sub-pattern disposed on the one side surface of the inner cover to have a first width and a first length,
a distance between points connecting from the second sub-pattern to the third sub-pattern is configured as a second width smaller than the first width, and
a distance between points connecting from the first sub-pattern to the second sub-pattern is configured to as a third width smaller than the second width.

17. The antenna assembly of claim 16, wherein the second conductive pattern is connected to the first sub-pattern in the inclined region of the inner cover, and the first end point is disposed to be curved inwardly toward the feed point, and
the third conductive pattern is connected to the first sub-pattern in the inclined region of the inner cover, and the second end point is disposed to be curved inwardly toward the feed point.

18. The antenna assembly of claim 14, further comprising a printed circuit board (PCB) connected, at the feed point, to the conductive pattern disposed on the front surface of the inner cover, and disposed between the metal frame and the outer cover,
wherein the PCB has a feed pattern disposed thereon to be connected to the feed point of the conductive pattern.

19. The antenna assembly of claim 14, wherein the antenna assembly is disposed inside a rear seat monitor module disposed in a rear seat of a vehicle, and performs wireless communication within the vehicle and wireless communication between the vehicle and another vehicle or a wireless entity outside the vehicle.

20. The antenna assembly of claim 19, wherein the antenna assembly comprises a first antenna and a second antenna arranged on a left side and a right side of the rear seat monitor module, respectively, and a third antenna and a fourth antenna arranged on an upper left side and an upper right side of the rear seat monitor module, respectively, and
the first antenna is positioned in a further left region compared to the third antenna, and the second antenna is positioned in a further right region compared to the fourth antenna.
